# EUROPÄISCHE PATENTSCHRIFT

(11) **EP 1 387 459 B1**
(45) Veröffentlichungstag und Bekanntmachung des Hinweises auf die Patenterteilung: **22.04.2009**
(21) Anmeldenummer: 03015341.5
(22) Anmeldetag: 08.07.2003
(51) Int. Cl.: H02H 7/122

(54) **Verfahren zur Fehlererkennung bei einer Antriebseinrichtung**
Fault detection method for a drive assembly
Procédé de détection de défauts pour un dispositif d'entraînement

(30) Priorität: 02.08.2002 DE 10236377
(43) Veröffentlichungstag der Anmeldung: 04.02.2004
(73) Patentinhaber: Dr. Johannes Heidenhain GmbH, 83292 Traunreut (DE)
(72) Erfinder: Zehentner, Georg, 83317 Teisendorf (DE); Huber, Norbert, 83317 Teisendorf (DE); Kellner, Eugen, 83471 Berchtesgaden (DE)

(56) Entgegenhaltungen:
- WO-A-97/14205
- US-A- 5 266 891
- SPEE R ET AL: "REMEDIAL STRATEGIES FOR BRUSHLESS DC DRIVE FAILURES" IEEE TRANSACTIONS ON INDUSTRY APPLICATIONS, IEEE INC. NEW YORK, US, Bd. 26, Nr. 2, 1. März 1990 (1990-03-01), Seiten 259-266, XP000136699 ISSN: 0093-9994

## Beschreibung

Die Erfindung betrifft ein Verfahren zur Fehlererkennung bei einer Antriebseinrichtung nach dem Gattungsbegriff des Patentanspruchs 1.

Ein derartiges Verfahren ist vorgesehen zur Fehlererkennung bei einer Antriebseinrichtung mit einem Mehrphasen-Elektromotor, insbesondere Drehstrommotor, und einem dem Elektromotor vorgeschalteten Leistungsteil in Form eines Stromrichters (Umrichters), wobei der Stromrichter die Spannung an den Phasen des Elektromotors steuert und die (von den besagten Spannungen abhängigen) Phasenströme in den einzelnen Phasen des Elektromotors jeweils periodisch verlaufen. Die Phasenströme werden dabei zur Fehlererkennung gemessen.

Verfahren zur Fehlererkennung bei einer Antriebseinrichtung unter Messung von Phasenströmen sind beispielsweise aus der US-PS 5,266,891 und der EP 0 848 492 A1 bekannt. Auch der Aufsatz "Remedial Strategies for brushless DC drive failures", IEEE transactions on industrie applications 26(1990), No. 2, Seiten 259-266 von Spée et al. beschäftigt sich mit Fehlererkennung in Antriebseinrichtungen, und vor allem mit Abhilfemöglichkeiten bei erkannten Fehlern.

Der Erfindung liegt das Problem zu Grunde, ein verbessertes Verfahren zur Fehlererkennung bei einer Antriebseinrichtung zur Verfügung zu stellen.

Dieses Problem wird erfindungsgemäß durch ein Verfahren mit den Merkmalen des Patentanspruchs 1 gelöst.

Danach werden zur Fehlererkennung die Phasenströme an einem vorgegebenen Punkt der jeweiligen Periode, dass heißt bei einem vorgegebenen Stromwinkel, unter gleichzeitiger Variation der Spannungen an den Phasen des Elektromotors gemessen und die Messwerte in Abhängigkeit von der Spannung an der jeweiligen Phase des Elektromotors ausgewertet.

Die erfindungsgemäße Lösung eignet sich für die Fehlererkennung in Antriebseinrichtungen für Werkzeugmaschinen und ermöglicht eine Lokalisierung von Fehlem, so dass insbesondere zwischen einem Fehler im Stromrichter und einem Fehler im nachgeschalteten Elektromotor ohne Verwendung separater Messeinrichtungen für den Stromrichter einerseits und dem Elektromotor andererseits unterschieden werden kann. Dies ermöglicht darüber hinaus eine Ferndiagnose von Fehlern mittels eines Modems oder über Intemet.

Die Möglichkeit der Unterscheidung zwischen Fehlern im Stromrichter einerseits und im Elektromotor andererseits ergibt sich daraus, dass zur Fehlererkennung nicht einfach die Phasenströme in den einzelnen Phasen des Elektromotors bei bestimmten Stromwinkeln gemessen werden, sondern dass hierbei gleichzeitig eine Variation der die Ströme erzeugenden elektrischen Spannungen stattfindet. Das Verhalten der Ströme in Abhängigkeit von der zu Grunde liegenden elektrischen Spannung ermöglicht eine Auswertung, die zu einer Unterscheidung zwischen Fehlern im Stromrichter einerseits und im Elektromotor andererseits führt. Dies wird weiter unten anhand von Beispielen im Einzelnen dargelegt werden. Wichtig ist hierbei, dass die Spannungen während der Messung der Phasenströme derart variiert werden, dass sich der Stromwinkel nicht ändert, also die Phasenströme während einer Messung jeweils an einem einzigen, konstanten Punkt der Periode untersucht werden.

Bei den zu detektierenden Fehlern des Elektromotors handelt es sich insbesondere um eine Unterbrechung in den Leitungen einer Phase des Elektromotors, z. B. als Folge eines Leitungsbruches oder eines nicht geschlossenen Kontaktes. Bei den innerhalb des Stromrichters zu detektierenden Fehlem kann es sich vor allem um ein fehlerhaftes, das heißt nicht korrekt schaltendes Stromrichterventil in Form eines Transistors, insbesondere eines sogenannten IGBT (Insulated-Gate-Bipolar-Transistor), handeln.

Eine Unterbrechung in einer Phase des Elektromotors wird dadurch erkannt, dass der entsprechende Phasenstrom unabhängig von dem Wert der zu Grunde liegenden elektrischen Spannung stets annähernd gleich null ist. (Der exakte Wert "0" tritt aufgrund von Messeinflüssen in der Regel nicht auf.). Demgegenüber ist bei einem fehlerhaften, nicht korrekt schaltenden Stromrichterventil nur für einen Teilbereich der zugrundeliegenden elektrischen Spannungskurve ein (bei einem korrekt schaltenden Stromrichterventil nicht auftretender) Abfall auf den Stromwert null zu beobachten.

Zur Auswertung der Phasenströme wird ein solcher Stromwinkel gewählt, dass mindestens einer der Phasenströme während der Messung stets gleich Null ist. Bei sinusförmig verlaufenden Phasenströmen kann die Messung der Phasenströme beispielsweise bei einem Stromwinkel erfolgen, an dem einer der Phasenströme einen Nulldurchgang aufweist.

Die Spannungen werden während der Messungen der Phasenströme vorzugsweise derart variiert, dass das Verhältnis der Spannungen während der Messung konstant bleibt. Insbesondere können zwei der Spannungen so variiert werden, dass dies Summe der Spannungen während der Messung stets gleich null ist. In einer bevorzugten Ausführungsform der Erfindung werden die Spannungen an den einzelnen Phasen des Elektromotors während der Messung jeweils periodisch variiert, wobei die Spannungen während einer Messung jeweils eine voller Periode durchlaufen.

Die Variation der Spannungen kann in einfacher Weise auf der Basis einer Sinus-Kurve erfolgen, so dass die Spannungen Nulldurchgänge erweisen, die für die konkrete AusWertung der gemessenen Phasenströme von Bedeutung sind, wie weiter unten erläutert werden wird.

Die Messung der Phasenströme kann bei mehreren unterschiedlichen Stromwinkeln erfolgen, wobei die Anzahl der Messungen bei unterschiedlichen Stromwinkeln vorzugsweise der Anzahl der Phasen des Elektromotors entspricht und bei jeder der Messungen ein anderer der Phasenströme den Wert null aufweist.

Zur Auswertung der Messergebnisse im Hinblick auf die Fehlererkennung können die gemessenen Phasenströme jeweils an definierten, anhand des Verlaufs zu Grunde liegenden elektrischen Spannungen bestimmbaren Punkten des jeweiligen Stromverlaufs ausgewertet werden, beispielsweise am Maximum des jeweiligen Phasenstromes zwischen einem Maximum und einem Nulldurchgang der zugehörigen Spannung. Die Auswertung der Messergebnisse kann dann in einfacher Weise in tabellarischer Form erfolgen.

Es ist nicht erforderlich, sämtliche Phasenströme direkt zu messen, da einer der Phasenströme indirekt aus den übrigen Phasenströmen ermittelt werden kann.

Die Eingangssignale des Stromrichters werden durch Ausgangssignale eines Reglers, insbesondere durch pulsweitenmodulierte Signale (PWM-Signale), bestimmt. Daher ist es zweckmäßig, die Ausgangssignale des Reglers an der Schnittstelle zwischen Regler und Stromrichter im Hinblick auf Fehler zu untersuchen. Hierbei wird überprüft, ob bestimmte, vorgegebene Muster der Ausgangssignale des Reglers die zu erwartenden Eingangssignale (Spannungssignale) am Stromrichter erzeugen. Ein Fehler liegt dann vor, wenn bestimmte vorgegebene Ausgangssignale des Reglers nicht zu der erwarteten Spannungssignalen führen. Zur Auswertung der Spannungssignale werden diese über ein logisches Gatter, insbesondere EXOR-Gatter miteinander verknüpft.

Weiterhin kann im Rahmen der vorliegenden Erfindung ergänzend geprüft werden, ob ein Kurzschluss zwischen zwei Phasen des Elektromotors vorliegt. Die Prüfung auf Kurzschluss erfolgt immer dann, wenn die Messung der Phasenströme auf Grund eines Überstromes in einem der Stromrichterventile des Stromrichters abgebrochen werden musste. Die Detektion eines solchen Überstromes kann in einfacher Weise in dem jeweiligen Stromrichterventil selbst erfolgen, das als Folge des Überstromes abschaltet.

Zur Prüfung auf Kurzschluss werden jeweils zwei Phasen des Elektromotors auf das gleiche elektrische Potenzial gelegt und es wird sodann geprüft, ob die Größe eines der Phasenströme auf einen Kurzschluss hinweist. Die Festlegung des elektrischen Potenzials der einzelnen Phasen kann dabei durch geeignete Wahl eines Stromwinkels erfolgen. Indem nacheinander alle möglichen Kombinationen zweier Phasen des Elektromotors auf das gleiche elektrische Potenzial gelegt werden, lässt sich bei Auftreten von Kurzschlussströmen ermitteln, welche der beiden Phasen kurzgeschlossen sind. Denn der Kurzschluss kann jeweils nicht von den Phasen herrühren, die sich auf dem gleichen elektrischen Potenzial befinden.

Sollten bei allen Kombinationen Kurzschlussströme auftreten, so kann anschließend eine Prüfung auf einen Erdschluss einer Phasen durchgeführt werden. Hierzu werden die einzelnen elektrischen Schaltungen des Stromrichters, die jeweils einer der Phasen des Elektromotors zugeordnet sind, mit identischen Eingangssignalen beaufschlagt. Diese elektrischen Schaltungen können jeweils durch paarweise angeordnete Transistoren oder Thyristoren, insbesondere in Form paarweise angeordneter IGBTs, mit zugeordneten Freilaufdioden gebildet werden.

Durch die den einzelnen Phasen des Elektromotors zugeordneten elektrischen Schaltungen wird in Abhängigkeit von dem jeweiligen Eingangssignal des Stromrichters jeweils eine von zwei möglichen Spannungen als elektrisches Potential an die entsprechende Phase des Elektromotors angelegt. Ein Erdschluss liegt in diesem Fall dann vor, wenn ein Strom auftritt, obwohl alle Phasen des Elektromotors auf ein identisches elektrisches Potenzial gelegt worden sind.

Die erfindungsgemäße Lösung und ihre vorstehend beschriebenen Weiterbildungen sind insbesondere geeignet zur Verwendung bei einem Drei-Phasen-Drehstrom-Motor.

Weitere Merkmale und Vorteile der Erfindung werden bei der nachfolgenden Beschreibung der Figuren deutlich werden.

Es zeigen:
- Figur 1: ein schematisches elektrisches Schaltbild eines Elektromotors mit einem vorgeschalteten Frequenz-Umrichter;
- Figur 2: ein Flussdiagramm eines Verfahrens zur Fehlererkennung bei einer Antriebseinrichtung gemäß Figur 1;
- Figur 3: eine schematische Darstellung einer Auswerteschaltung zur Ermittlung von Fehlern an der Schnittstelle zwischen dem Frequenz-Umrichter aus Figur 1 und einem vorgeschalteten Regler;
- Figur 4: eine Tabelle zur Auswertung der Schaltung gemäß Figur 3;
- Figur 5: ein Flussdiagramm zur näheren Erläuterung eines Verfahrensschrittes aus Figur 2 betreffend die Unterscheidung von Fehlern in dem Elektromotor einerseits und dem vorgeschalteten Frequenz-Umrichter andererseits;
- Figur 6: eine Darstellung des idealen Verlaufs der Phasenströme in dem Elektromotor aus Figur 1;
- Figuren 7a bis 16c: unterschiedliche relevante Messergebnisse bei Durchführung des Verfahrens gemäß Figur 5;
- Figur 17: eine tabellarische Darstellung der Ergebnisse eines Verfahrens zur Erkennung eines Kurzschlusses zwischen zwei Phasen des Elektromotors aus Fig. 1;
- Figur 18: ein Flussdiagramm zur Erkennung eines Erdschlusses in einer der Phasen des Elektromotors aus Figur 1.

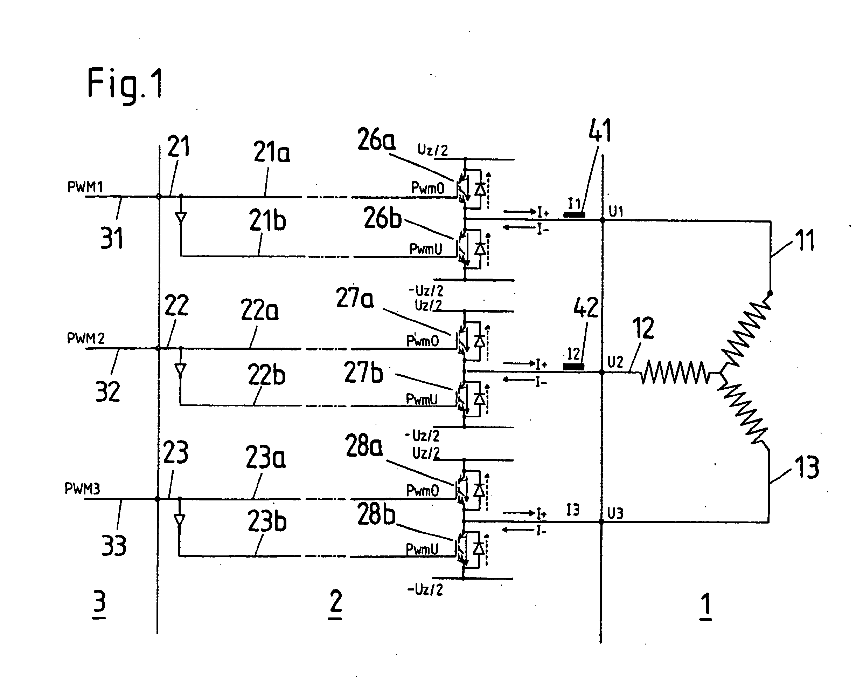

In Figur 1 ist eine Antriebseinrichtung für Werkzeugmaschinen dargestellt, die einen Mehrphasen-Elektromotor in Form eines Dreiphasen-Drehstrom-Motors 1, einen dem Motor 1 vorgeschalteten Stromrichter in Form eines Frequenz-Umrichters 2 sowie einen Regler 3 zur Erzeugung von PWM-Signalen für den Umrichter 2 aufweist. Die drei Phasen 11, 12, 13 des Antriebsmotors 1 sind in Figur 1 schematisch als Spulen mit einer zugeordneten Zuleitung dargestellt.

Der dem Antriebsmotor 1 vorgeschaltete Umrichter 2 (Leistungsteil) wird gebildet durch drei Paare 26a, 26b; 27a, 27b; 28a, 28b von IGBTs mit zugehörigen Freilaufdioden. Ferner ist jedem IGBT 26a, 26b; 27a, 27b; 28a, 28b eine elektrische Zuleitung 21a, 21b; 22a, 22b bzw. 23a, 23b zugeordnet.

Jedes dieser Paare 26a, 26b; 27a, 27b; 28a, 28b von IGBTs bildet zusammen mit den zugehörigen Freilaufdioden und den Zuleitungen 21a, 21b; 22a, 22b; 23a, 23b eine elektrische Schaltung 21, 22 bzw. 23, die in Abhängigkeit von den Eingangssignalen des Umrichters 2 bzw. den Ausgangssignalen des Reglers 3 eine obere Zwischenkreisspannung Uz/2 oder eine untere Zwischenkreisspannung -Uz/2 an die jeweils zugeordnete Phase 11, 12 oder 13 des Antriebsmotors 1 schaltet. Zwei der hieraus resultierenden Phasenströme l1, l2 in der ersten Phase 11 bzw. der zweiten Phase 12 des Antriebsmotors 1 werden mittels Stromsensoren 41, 42 gemessen. Der Phasenstrom I3 in der dritten Phase 13 des Antriebsmotors 1 lässt sich aus den gemessenen Werten der beiden anderen Phasenströme l1, l2 ermitteln. Ein Strom kann dabei innerhalb des Antriebsmotors nur dann fließen, wenn mindestens zwei der drei Spannungen U1, U2, U3 an den Phasen 11, 12, 13 des Elektromotors 1 unterschiedlich sind, also mindestens eine der Spannungen U1, U2, U3 auf den Wert Uz/2 und eine andere auf den Wert -Uz/2 gelegt worden ist.

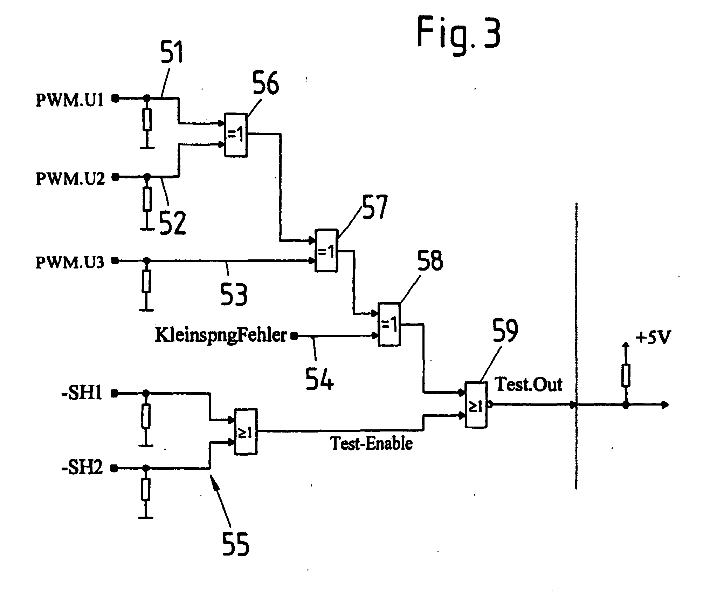

Von dem Regler 3, dessen Ausgangssignale PWM1, PWM2 und PWM3 die Eingangssignale des Umrichters 2 bestimmen, sind in Figur 3 lediglich elektrische Leitungen 31, 32, 33 dargestellt, die die Schnittstelle zu dem Umrichter 2 bilden und die jeweils einer der elektrischen Schaltungen 21, 22, 23 des Umrichters 2 zugeordnet sind. Bei den vom Regler 3 erzeugten Ausgangssignalen handelt es sich jeweils um Rechtecksignale, deren Tastverhältnis abhängig von dem gewünschten Strorn-Sollwerten im Antriebsmotor 1 ist.

Antriebseinrichtungen für Werkzeugmaschinen der in Figur 1 dargestellten Art sind bekannt. Nachfolgend wird anhand der weiteren Figuren beschrieben werden, wie bei einer solchen Antriebseinrichtung eine Fehlererkennung durchgeführt werden kann, die nicht nur eine zuverlässige Erkennung auftretender Fehler, sondern auch deren Lokalisierung ermöglicht. Insbesondere soll zwischen dem Auftreten eines Fehlers im Antriebsmotor 1 und im Umrichter 2 unterschieden werden können, ohne hierfür zusätzliche Messeinrichtungen, insbesondere separate Messeinrichtungen zur Erkennung von Fehlern im Antriebsmotor 1 einerseits und im Umrichter 2 andererseits, vorzusehen.

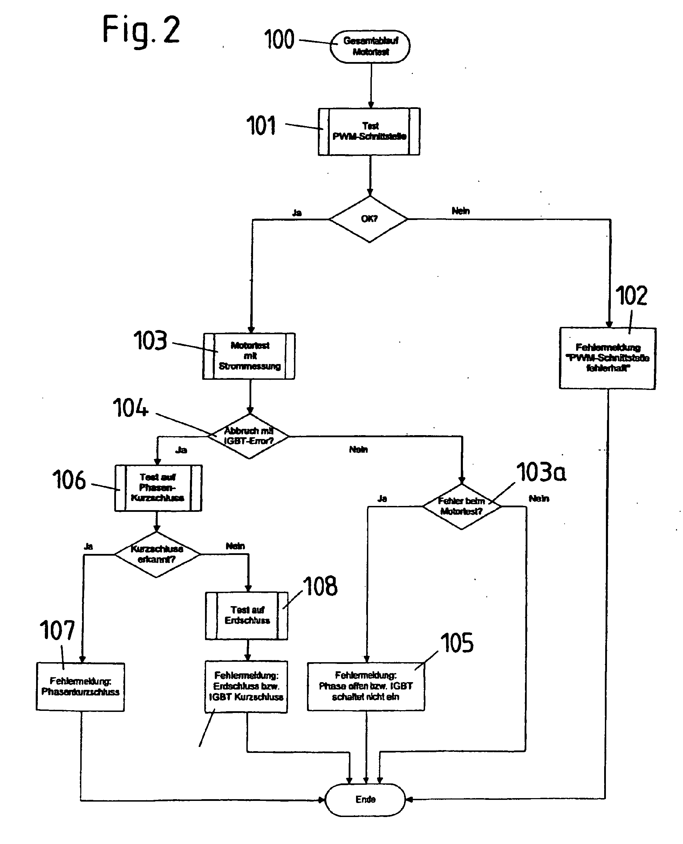

Figur 2 zeigt in einem Flussdiagramm eine Übersicht über den Gesamtablauf eines Fehlertestes 100 für die Antriebseinrichtung aus Figur 1.

In einem ersten Testschritt 101 wird die Schnittstelle zwischen dem Regler 3 und dem Umrichter 2 geprüft, d. h. es wird getestet, ob die durch den Regler 3 erzeugten PWM-Signale korrekt im Umrichter 2 ankommen und ob alle benötigten Hilfsspannungen zur Ansteuerung der IGBTs vorliegen. Wird bei diesem Test ein Fehler festgestellt, so wird die Fehlermeldung 102 "PWM-Schnittstelle fehlerhaft" erzeugt und der Test beendet. Denn weitere Testfunktionen sind nicht sinnvoll ausführbar, solange nicht sichergestellt ist, dass dem Umrichter 2 korrekte Eingangssignale zugeführt werden.

Wenn bei dem Test der Schnittstelle zwischen Umrichter 2 und Regler 3 keine Fehler auftraten, dann wird im nächsten Schritt 103 ein "Motortest mit Strommessung" durchgeführt. Hierbei werden für drei unterschiedliche Stromwinkel des den Antriebsmotor 3 antreibenden Drehstromes die zugrunde liegenden elektrischen Spannungen sinusförmig variiert. Der Stromwinkel wird dabei derart gewählt, dass in einer der drei Motorphasen der Strom gleich Null ist, die zugehörige Spannung also ebenfalls konstant den Wert Null aufweist.

Durch eine getrennte Auswertung der beiden Halbwellen der sinusförmig verlaufenden Spannungen ergeben sich bei drei unterschiedlichen Stromwinkeln insgesamt sechs auswertbare Messungen der Phasenströme. Die Auswertung erfolgt mittels einer Tabelle, anhand deren Einträgen sich feststellen lässt, ob ein Fehler in der Antriebseinrichtung auf einen nicht einschaltenden IGBT oder eine Unterbrechung in einer Phase des Antriebsmotors zurückgeht. Hierbei wird der Effekt ausgenutzt, dass der jeweils induzierte Phasenstrom je nach Vorzeichen über die zugehörige Freilaufdiode zur positiven oder negativen Zwischenkreis-Spannungsschiene in der entsprechenden elektrischen Schaltung 21, 22, 23 des Umrichters 2 abfließt.

Während dieses Testes wird gleichzeitig auch abgefragt, ob einer der IGBTs des Umrichters 2 wegen Überstromes abschaltet. Wird kein IGBT-Error 104 in Form eines Überstromes festgestellt, so erfolgt die Auswertung 103a der Messwerte aus den Strommessungen 103 und es wird gegebenenfalls eine Fehlermeldung 105 ausgegeben, die auf eine offene Phase in dem Antriebsmotor 1 oder einen Fehler in dem Umrichter 2 (nicht einschaltender IGBT) hinweist.

Wird demgegenüber in einem der IGBTs ein Überstrom festgestellt, so wird in einem nächsten Schritt 106 überprüft, ob ein Phasen-Kurzschluss vorliegt, d.h., ob zwei Phasen des Antriebsmotors 1 kurzgeschlossen sind. Hierzu werden wiederum Messungen bei drei unterschiedlichen Stromwinkeln durchgeführt, wobei die Stromwinkel der einzelnen Messungen so gewählt werden, dass jeweils zwei der Phasen auf dem gleichen elektrischen Potential liegen, also auf die gleiche Zwischenkreis-Spannung geschaltet worden sind. Bei der Auswertung der Messungen wird berücksichtigt, dass bei Vorliegen eines Kurzschlusses zweier Phasen während der Strommessung nur dann keine Abschaltung wegen eines Überstromes stattfindet, wenn gerade zwischen den beiden betroffenen Phasen keine Potentialdifferenz vorliegt, also die beiden Phasen auf die gleiche Zwischenkreisspannung geschaltet worden sind. Nach Erkennen eines Kurzschlusses wird der Test mit der Fehlermeldung 107 "Phasenkurzschluss" beendet.

Findet bei allen drei Stromwinkeln eines Abschaltung wegen eines Überstromes statt, so wird ein Test 108 auf Erdschluss durchgeführt. Dabei werden die Ausgangssignale (PWM-Signale) des Reglers 3 zunächst fest auf "1" und dann fest auf "0" eingestellt. Falls ein Erdschluss vorliegt, so wird bei beiden Messungen eine Abschaltung wegen eines auftretenden Überstromes erfolgen. Bei einem Kurzschluss innerhalb eines IGBT wird demgegenüber ein Überstrom nur dann auftreten, wenn der dem defekten IGBT als Partner zugeordnete weitere IGBT eingeschaltet worden ist. Hierdurch kann also unterschieden werden, ob ein Überstrom auf einen Erdschluss einer der Phasen des Antriebsmotors 1 oder auf einen Kurzschluss innerhalb eines IGBT des Umrichters 2 zurückgeht. Durch Beobachtung und Auswertung der gemessenen Ströme kann dabei auch ein hochohmiger Erdschluss bzw. Kurzschluss erkannt werden.

Im Folgenden werden die anhand Figur 2 im Zusammenhang dargestellten Fehlertests einzeln näher erläutert werden.

Figur 3 zeigt eine Auswerteschaltung zur Durchführung und Auswertung des Testes 101 (Figur 2) auf Fehler an der Schnittstelle zwischen Regler 3 und Umrichter 2. Die Auswerteschaltung umfasst drei Anschlüsse, die jeweils einer der drei Zuleitungen 31, 32, 33 (Figur 1) an der Schnittstelle von Regler 3 und Umrichter 2 zugeordnet sind. Die ersten beiden Anschlüsse sind über jeweils eine elektrische Leitung 51, 52 mit den beiden Eingängen eines logischen Gatters 56 in Form eines EXOR-Gatters verbunden. Das Ausgangssignal dieses ersten EXOR-Gatters 56 wird einem zweiten EXOR-Gatter 57 zugeführt, dessen Eingang außerdem das an dem dritten Anschluss der Auswerteschaltung auftretende Signal über eine Leitung 53 zugeführt ist. Das zweite EXOR-Gatter 57 ist wiederum ausgangsseitig mit einem Eingang eines dritten EXOR-Gatters 58 verbunden, dem außerdem das Ergebnis einer Selbsttest-Schaltung 54 zugeführt wird, die das Vorhandensein aller zum Ansteuern der IGBTs benötigten Kleinspannungen (in Höhe von 15V bzw. 24V) prüft. Das Ausgangssignal des dritten EXOR-Gatters 58 wird einem logischen Gatter 59 in Form eines NOR-Gatters zugeführt, das eingangsseitig außerdem mit einer Schaltung 55 zum Aktivieren des Tests der Schnittstelle verbunden ist.

Zur Durchführung des Fehlertests an der Schnittstelle zwischen Regler 3 und Umrichter 2 wird der Regler derart betätigt, dass definierte Muster an PWM-Signalen an den die Schnittstelle bildenden Leitungen 31, 32, 33 zu erwarten sind. Jedes dieser Muster entspricht einer bestimmten Verteilung der Werte "1" und "0" für die PWM-Signale PWM1, PWM2 und PWM3, die von dem Regler 3 in den entsprechenden Leitungen 31, 32, 33 der Schnittstelle zur Verfügung gestellt werden sollen. Die aufgrund dieser Signale in den eingangsseitigen Leitungen 51, 52, 53 der Auswerteschaltung 5 erzeugten Spannungssignale PWM.U1, PWM.U2, PWM.U3, die jeweils den entsprechenden Wert "1" bzw. "0" des zugehörigen PWM-Signales repräsentieren, werden in den ersten beiden EXOR-Gattern 56, 57 miteinander verknüpft. Dazu kommt noch die Verknüpfung mit der Selbsttest-Schaltung 54, die das Vorhandensein aller erforderlichen Kleinspannungen überprüft und im Fehlerfall den Wert "1" und im Übrigen den Wert "0" an den entsprechenden Eingang des dritten EXOR-Gatters 58 legt. Das Ergebnis dieser drei Verknüpfungen in den EXOR-Gattern 56, 57, 58 wird dem NOR-Gatter 59 (Invertierer) zugeführt, das bei Aktivierung der Test-Schaltung außerdem von den Steuerleitungen zur Testaktivierung eingangsseitig mit dem Wert "0" beaufschlagt wird, da dann beide Steuerleitungen SH1, SH2 jeweils auf den Wert "0" gelegt sind.

Zur Auswertung der mittels der Auswerteschaltung 5 gemessenen Werte werden die Muster der drei PWM-Signale PWM1, PWM2, PWM3 sowie das in Abhängigkeit von dem jeweiligen Muster gemessene Ausgangssignal des NOR-Gatters 59 in einer Tabelle abgelegt.

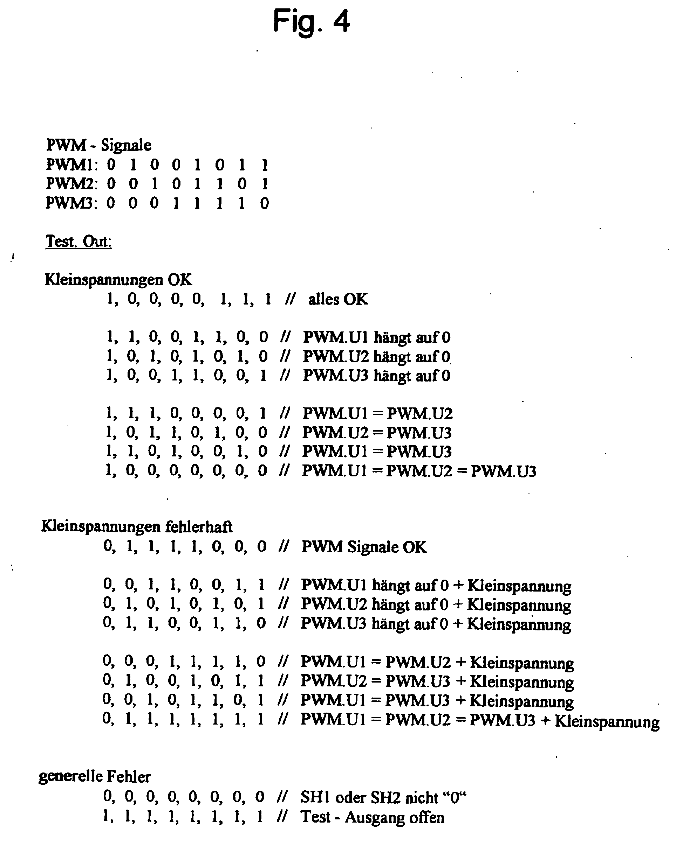

In Figur 4 ist tabellarisch für alle acht möglichen Muster der drei PWM-Signale, von "000" bis "110", jeweils angegeben, welche Werte ("Test.Out") ausgangsseitig an dem NOR-Gatter 59 auftreten können und welche Schlüsse hieraus gezogen werden können.

Die ersten drei Zeilen der Tabelle aus Figur 4 geben die möglichen Kombinationen (Muster)der drei PWM-Signale PWM1, PWM2, PWM3 an, in Abhängigkeit von denen das Ausgangssignal ("Test Out") am NOR-Gatter 59 erzeugt wird. Die acht Spalten der Tabelle beziehen sich dabei auf die acht unterschiedlichen möglichen Kombinationen der drei PWM-Signale.

Die nächsten acht Zeilen der Tabelle, unter der Überschrift "Kleinspannungen OK" geben die möglichen Ausgangssignale ("Test.Out") für alle acht Kombinationen an PWM-Signalen in dem Fall an, in dem kein Kleinspannungsfehler vorliegt. Die erste dieser acht Zeilen repräsentiert den Fall, dass kein Fehler an der Schnittstelle zwischen Regler 3 und Umrichter 2 zu beobachten ist. In diesem Fall wird bei der Signalkombination "000" an den Eingängen der Auswerteschaltung am Ausgang des NOR-Gatters 59 der Wert "1" auftreten; bei der eingangsseitigen Signalkombination "100" tritt ausgangsseitig der Wert "0" auf; usw.

Die nächsten sieben Zeilen stellen jeweils Ergebnisse dar, bei denen das an der Schnittstelle auftretende Signal nicht dem aufgrund der Einstellung des Reglers erwarteten Signal entspricht. Die entsprechenden Fehler, die sich jeweils durch Auswertung der acht möglichen Kombinationen der gewünschten PWM-Signale sowie des zugehörigen Ausgangssignales ("Test.Out) am Invertierer 59 ergeben, sind jeweils am Ende der Tabelle angedeutet.

Die nächsten acht Zeilen der Tabelle befassen sich mit dem Fall, dass beim Selbsttest der Kleinspannungen ein Fehler aufgetreten ist und dementsprechend an dem dritten EXOR-Gatter 58 durch die entsprechende Schaltung 54 eingangsseitig der Wert "1" angelegt wird.

Die Fehlermeldung "PWM.U1 hängt auf 0" weist beispielsweise darauf hin, dass in der entsprechenden Zuleitung 51 das durch eine Spannung repräsentierte Signal PWM.U1 stets den Wert "0" annimmt, obwohl in Abhängigkeit von dem jeweiligen Muster der drei PWM-Signale dieser Wert zwischen "0" und "1" pendeln sollte. Dieser Fehler kann beispielsweise auf einen Leitungsbruch zurückzuführen sein. Die Charakterisierung "PWM.U1=PWM.U2" weist darauf hin, dass in den beiden entsprechenden Leitungen 51, 52 der Auswerteschaltung 5 stets dasselbe Signal gemessen wird, obwohl dies lediglich bei vier der insgesamt acht möglichen Kombinationen der PWM-Signale der Fall sein dürfte.

Die letzten beiden Zeilen der Tabelle weisen auf "generelle Fehler" der Auswerteschaltung hin. Im ersten Fall ist die Testschaltung gar nicht aktiviert; der Fehler liegt also in den entsprechenden Steuerleitungen SH1, SH2. Im zweiten Fall ist der Ausgang der Testschaltung ("Test.Out") offen.

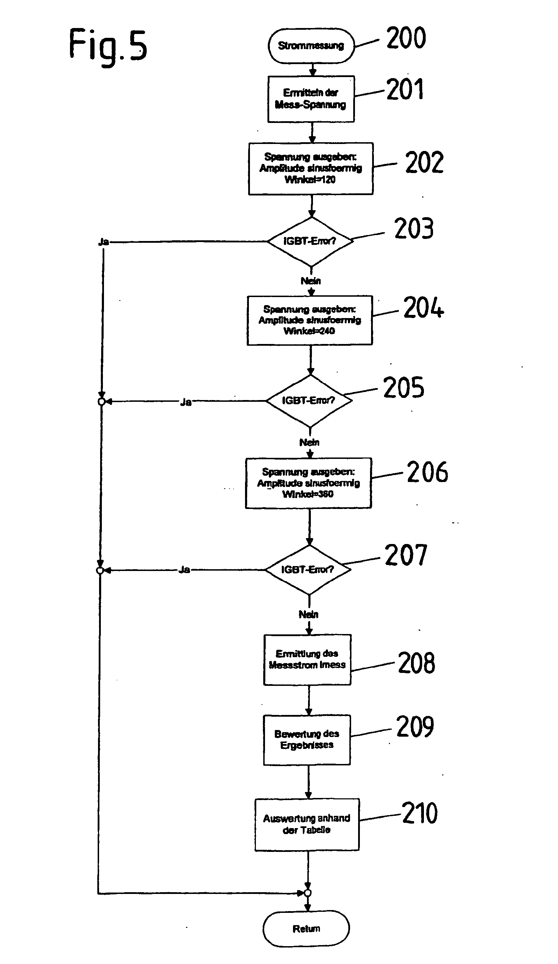

Nach Abschluss der anhand der Figuren 3 und 4 beschriebenen Überprüfung der an der Schnittstelle zwischen Regler 3 und Umrichter 2 anliegenden Signale erfolgt das eigentliche Kernstück der Fehlerdiagnose, nämlich die Ermittlung von Fehlem in dem Umrichter 2 oder dem Antriebsmotor 1 durch Messung der Phasenströme l1, l2, l3 in den einzelnen Phasen 11, 12, 13 des Antriebsmotors 1. Eine Übersicht über den Ablauf der entsprechenden Messungen ist in dem Flussdiagramm gemäß Figur 5 gezeigt.

Ziel dieses Testes ist es, nicht nur das Vorliegen eines Fehlers festzustellen, sondern den Ursprung des Fehlers zu lokalisieren, insbesondere zwischen einer Unterbrechung einer Phase des Antriebsmotors 1, z.B. infolge eines Leitungsbruchs (auch einer Wicklungsunterbrechung im Motor) oder eines offenen Kontaktes, und einem Fehler in dem Umrichter 2, z.B. als Folge eines nicht einschaltenden IGBT, zu unterscheiden.

Nach Aktivierung der Strommessung 200 werden zunächst die zugrundezulegenden Mess-Spannungen ermittelt. Hierzu wird aus den elektrischen Daten des Motors, die von der Motorsteuerung abgefragt werden können, diejenige Spannung ermittelt, die im Motor den für die Messung gewünschten Nennstrom induziert. Der tatsächlich induzierte Strom wird später während der Messung nochmals überprüft. Falls die Differenz zu dem gewünschten Nennstrom einen vorgegebenen Wert überschreitet, wird die Mess-Spannung angepasst, so dass im Antriebsmotor 1 für eine erneute Messung der zulässige Maximalstrom des Motors induziert wird. Für diese Anpassung der Spannung wird von einem linearen Zusammenhang zwischen Strom und Spannung ausgegangen. Stehen die elektrischen Daten des Motors nicht zur Verfügung, so besteht alternativ die Möglichkeit, sich von einer zunächst niedrig gewählten Spannung an den Nennstrom heranzutasten. Die Messspannung wird derart gewählt, dass sich die induzierten Phasenströme in dem Antriebsmotor 1 einerseits hinreichend deutlich vom Hintergrundrauschen abheben und dass andererseits eine Beschädigung des Antriebsmotors 1 durch zu große Ströme ausgeschlossen ist.

Nach Festlegung der Mess-Spannung erfolgt in einem nächsten Schritt 202 bei einem ersten Stromwinkel, bei dem einer der Phasenströme l1, l2, l3 gleich null ist, eine Messung der beiden übrigen Phasenströme in Abhängigkeit von einer sinusartigen Variation der Mess-Spannung, und zwar derart, dass die Spannung genau eine Periode durchläuft.

Im Anschluss daran wird überprüft, ob bei der Messung ein IGBT-Error 203 aufgetreten ist, d.h. ob einer der IGBTs des Umrichters 2 wegen eines Überstromes abgeschaltet worden ist. In diesem Fall wird die Messung mit einer entsprechenden Fehlermeldung beendet.

Andernfalls wird die Strommessung weitergeführt, und zwar bei zwei weiteren Stromwinkeln des zur Bestromung des Antriebsmotors 1 dienenden Drehstromes, so dass die Messung bei insgesamt drei Stromwinkeln durchgeführt wird und bei jeder Messung ein anderer der Phasenströme l1, l2, l3 den Wert 0 aufweist. Ferner wird nach jeder der weiteren Strommessungen 204, 206 das Vorliegen eines IGBT-Errors 205 bzw. 207 abgefragt und wiederum die Messung mit einer Fehlermeldung beendet, falls ein solcher vorliegt.

Ist bei keiner der Strommessungen ein IGBT-Fehler aufgetreten, so wird in einem nächsten Schritt 208 das Maximum des bei der Messung aufgetretenen Strombetrages ermittelt und als Imess zur Normierung der Ergebnisse verwendet. Anschließend erfolgen eine Bewertung 209 der Messergebnisse zur Vorbereitung der Fehlererkennung und eine Auswertung 210 der bewerteten Ergebnisse anhand einer Tabelle.

Nachfolgend wird nun die Durchführung der einzelnen Strommessungen, die Bewertung der Messergebnisse sowie die Auswertung der Ergebnisse zur Fehlererkennung genauer beschrieben werden. Die Auswertung wird nur dann vorgenommen, wenn nicht während der Strommessung einer der IGBTs wegen eines Überstromes abgeschaltet und die Messung insgesamt unterbrochen worden ist. Denn in diesem Fall würde, wie oben anhand an Figur 2 dargelegt, anstelle einer Auswertung der Strommessung eine Prüfung auf Phasenschluss bzw. Erdschluss erfolgen.

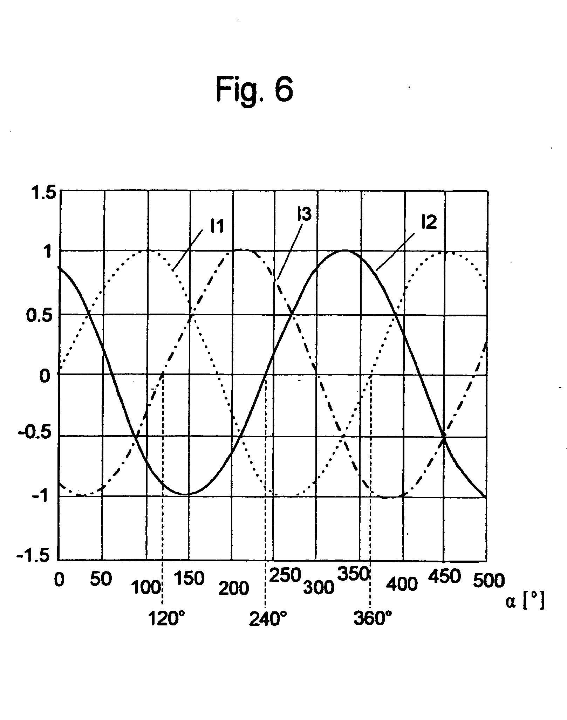

Figur 6 zeigt den idealen Verlauf der drei Phasenströme l1, l2, l3, des Antriebsmotors 1 in einem Winkelbereich zwischen 0° und 500°. Die drei Phasenströme l1, l2, l3 verlaufen jeweils sinusförmig und sind um 120° gegeneinander phasenverschoben. Der Verlauf der Phasenströme wird bestimmt durch die PWM-Signale, die als Ausgangssignale des Reglers 3 dem Umrichter 2 zugeführt werden und somit das Potential festlegen, auf das die einzelnen Phasen 11, 12, 13 des Antriebsmotors 1 zu einem jeweiligen Zeitpunkt gelegt werden.

Vorliegend werden zur Durchführung der Strommessungen, anhand derer Fehler im Umrichter 2 einerseits und im Antriebsmotor 3 andererseits festgestellt werden sollen, die PWM-Signale PWM1, PWM2 und PWM3 derart eingestellt, dass jeweils einer der drei Phasenströme l1, l2, l3 gleich null ist und die beiden anderen Phasenströme den gleichen Betrag aber entgegengesetztes Vorzeichen aufweisen. Dies ist bei den Stromwinkeln 120°, 240° sowie 360° der Fall, wie aus Figur 6 hervorgeht.

Anschließend werden bei dem jeweils vorgegebenen Stromwinkel die zugrundeliegenden Spannungen (Potentiale) an den Phasen 11, 12, 13 des Antriebsmotors 1 zeitlich derart variiert, dass die Phasen derjenigen beiden Ströme, die bei dem aktuellen Stromwinkel ungleich null sind, eine volle Sinusperiode durchlaufen und zu jedem Zeitpunkt denselben Betrag aber entgegengesetztes Vorzeichen aufweisen. Die dritte der drei Spannungen U1, U2, U3 ist dabei jeweils gleich null; sie gehört zu demjenigen Phasenstrom, der bei dem entsprechenden Stromwinkel den Wert null aufweist. Die Amplitude der zeitlich variierten Spannungen ist dabei festgelegt durch die Mess-Spannung, die vor Beginn der Messung wie oben beschrieben ermittelt worden ist.

In den nachfolgenden Figuren, die Ergebnisse der vorstehend beschriebenen Strommessungen zeigen, sind jeweils lediglich die ersten beiden Phasenströme l1, l2 (soweit ungleich null) und die zugehörigen Spannungen U1, U2 (soweit ungleich null) dargestellt.

Denn nur diesen beiden Phasenströmen l1, l2 ist gemäß Figur 1 jeweils ein Stromsensor 41 bzw. 42 zur Strommessung zugeordnet. Die Verhältnisse in der dritten Phase 13 des Antriebsmotors 1 lassen sich aus den Ergebnissen zu den beiden ersten Phasen 11, 12 errechnen.

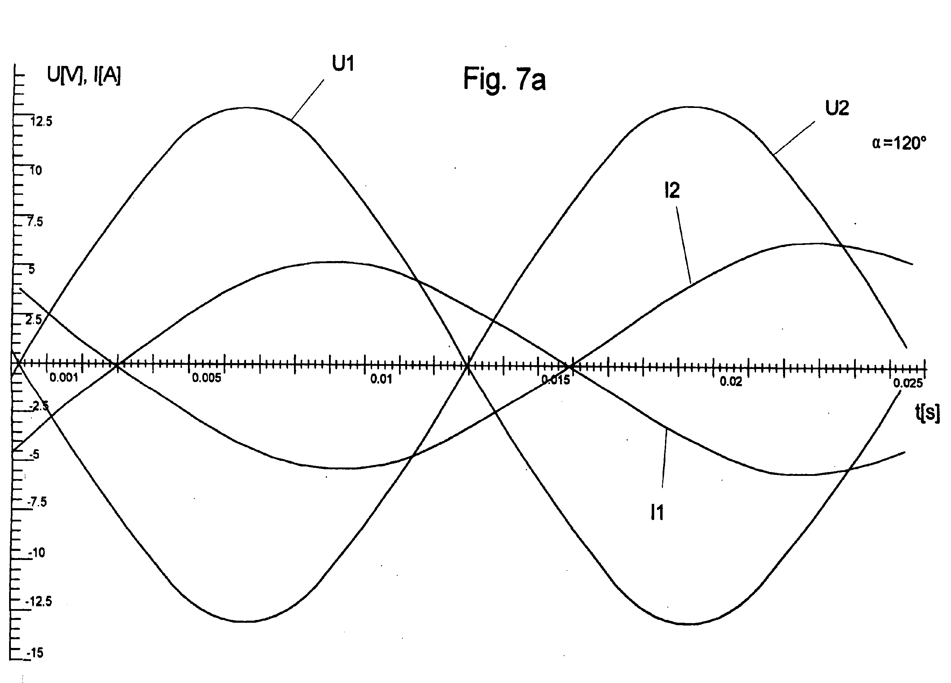

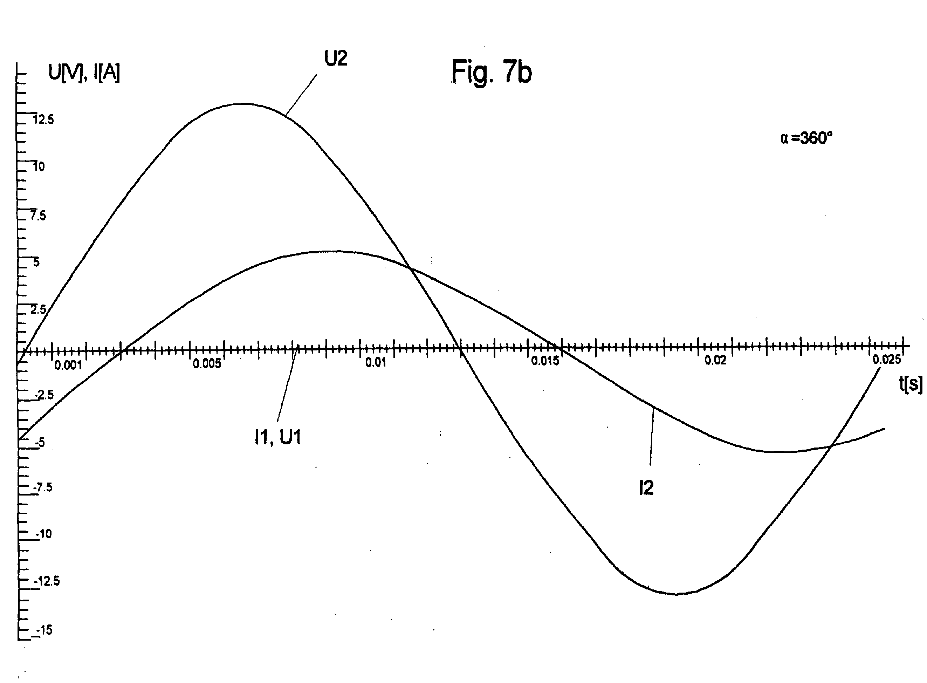

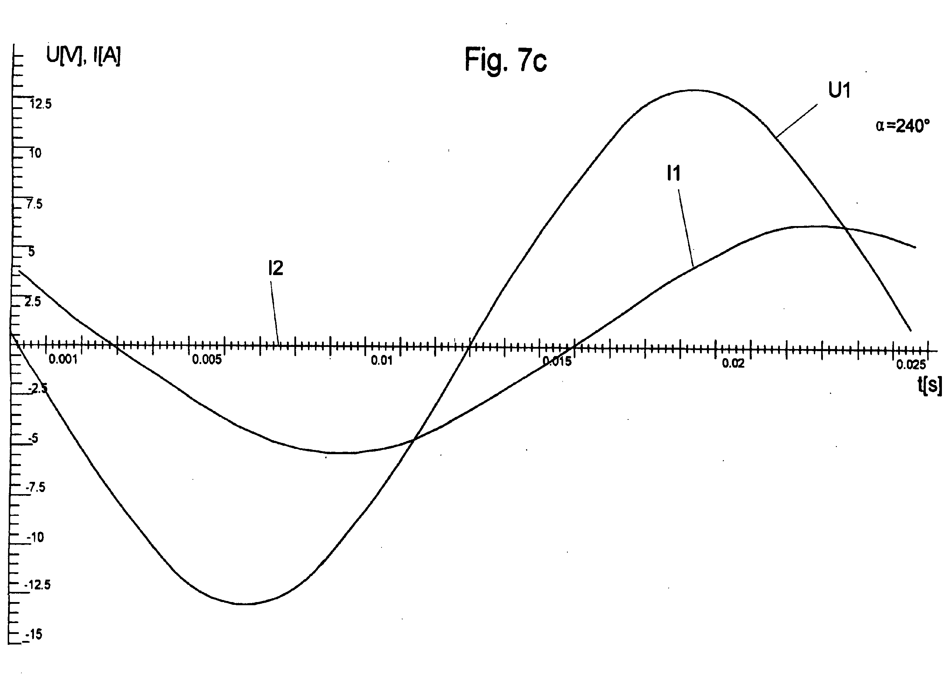

Die Figuren 7 a bis 7c zeigen die Ergebnisse der Messungen bei den Stromwinkeln 120°, 360° sowie 240°, und zwar bei einer Antriebseinrichtung, bei der weder in dem Umrichter 2 noch in dem Antriebsmotor 1 ein zu detektierender Fehler vorliegt. Es ist deutlich erkennbar, dass die gemessenen Phasenströme l1, l2 jeweils der zugeordneten Spannung U1 bzw. U2 nachlaufen. D.h., die Nulldurchgänge und Maxima der Phasenströme l1, l2 liegen zeitlich jeweils etwas hinter den entsprechenden Nulldurchgängen und Maxima der zugrundeliegenden Spannungen U1, U2.

Das Ergebnis der Messung bei einem Stromwinkel von 120° entsprechend Figur 7a zeigt weiterhin, dass die beiden gemessenen Phasenströme l1, l2 entsprechend den zugrundeliegenden Spannungen U1, U2 jeweils eine vollständige Periode durchlaufen.

Bei der in Figur 7b dargestellten Messung bei einem Stromwinkel von 360° sind der erste Phasenstrom l1 und die zugehörige Spannung U1 jeweils konstant gleich null, da dieser Phasenstrom l1 bei dem Stromwinkel 360° einen Nulldurchgang besitzt, vgl. Figur 6. Entsprechendes gilt bei der in Figur 7c dargestellten Messung bei einem Stromwinkel von 240° im Hinblick auf den zweiten Phasenstrom l2 und die zugehörige Spannung U2.

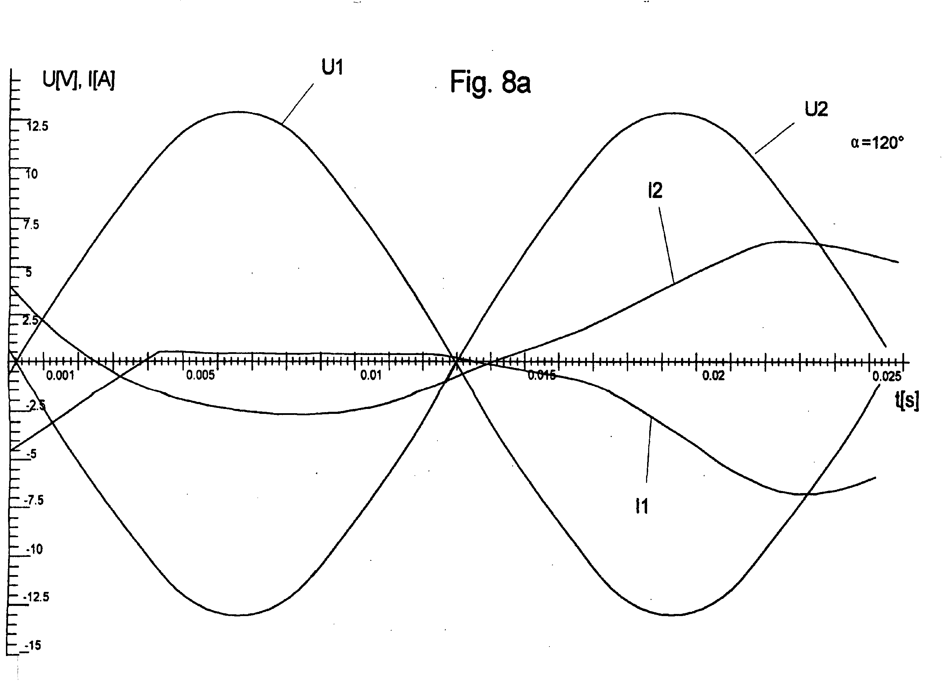

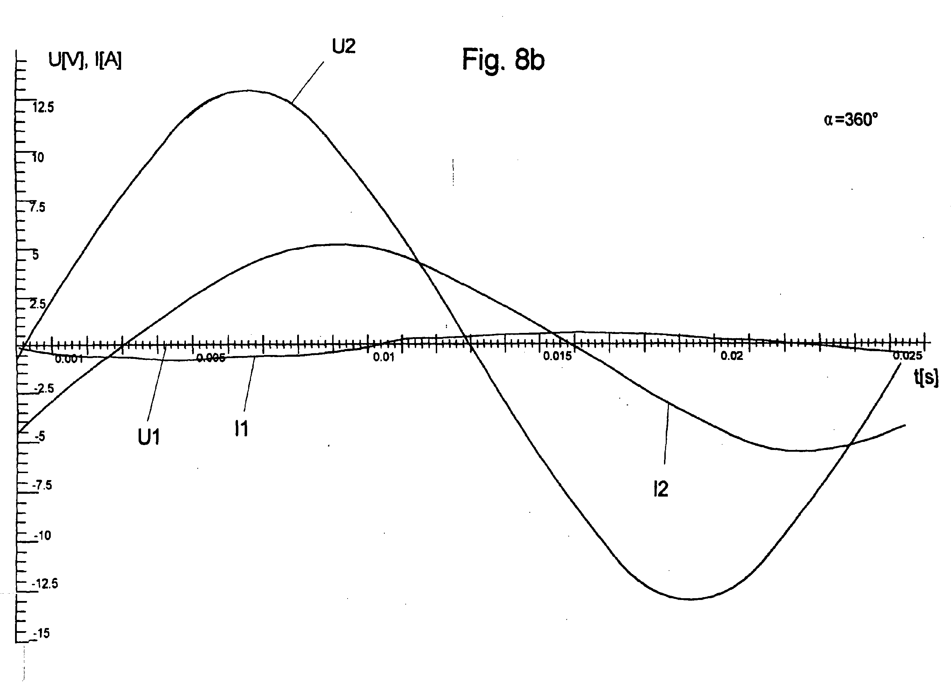

Die Figuren 8a bis 8c zeigen drei Messungen unter denselben Bedingungen wie anhand der Figuren 7a bis 7c beschrieben, wobei jedoch der obere IGBT 26a der ersten elektrischen Schaltung 21 des Umrichters 2 fehlerhaft ist, also nicht richtig einschaltet. Dies wird deutlich anhand des Verhaltens des ersten Phasenstromes 11 bei einer positiven zugeordneten Spannung U1.

Wie weiter oben anhand Figur 1 dargelegt, wird bei einer durch das entsprechende PWM-Signal PWM1, PWM2 bzw. PWM3 erzeugten positiven Spannung (entsprechend dem Wert "1" des PWM-Signales) jeweils der obere IGBT 26a, 27a, 28a der entsprechenden elektrischen Schaltung 21, 22, 23 eingeschaltet. Nimmt das zugeordneten PWM-Signal PWM1, PWM2 bzw. PWM3 demgegenüber den Wert "0" an und entsteht dementsprechend eine negative Spannung, so wird der jeweilige untere IGBT 26b, 27b, 28b des entsprechenden Paares 26a, 26b; 27a, 27b bzw. 28a, 28b eingeschaltet.

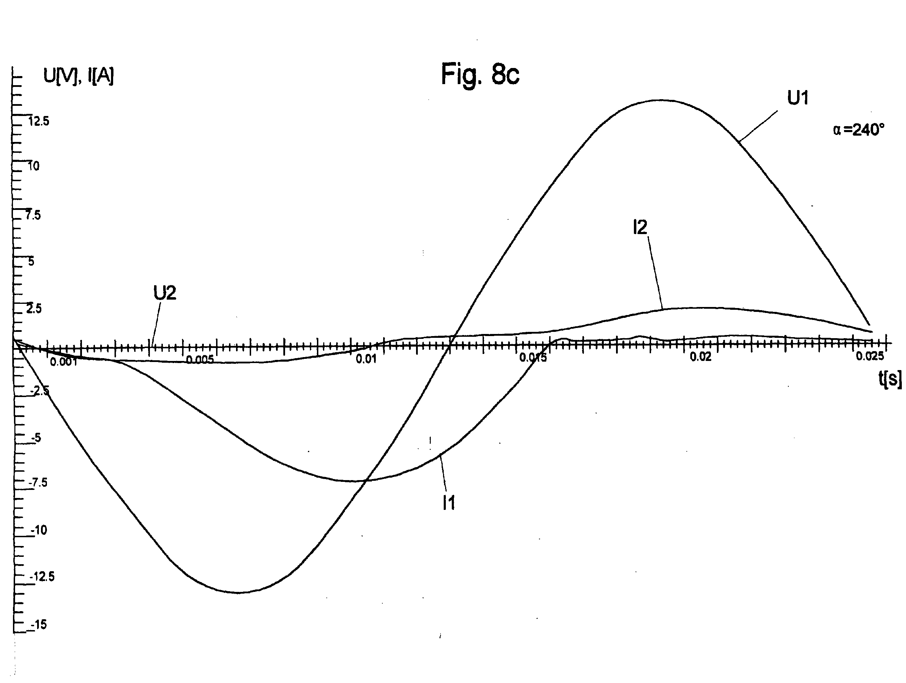

Vorliegend weist also die Tatsache, dass gemäß Figuren 8a und 8c bei einem Stromwinkel von 120° sowie 240° der erste Phasenstrom l1 jeweils dann null ist, wenn die zugeordnete Spannung U1 einen positiven Wert annimmt, daraufhin, dass der entsprechende IGBT 26a nicht korrekt eingeschaltet hat. Andernfalls hätte bei einem positiven Wert der genannten Spannung U1 ein entsprechender Wert größer null des ersten Phasenstromes l1 gemessen werden müssen, wie in den Figuren 7a und 7c bei einem fehlerfreien System dargestellt.

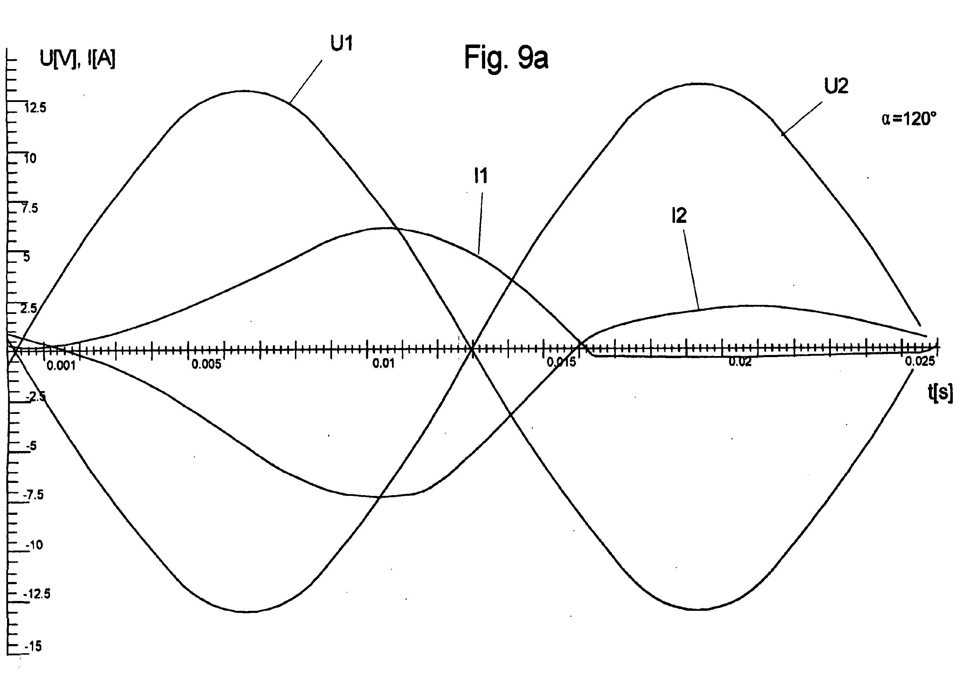

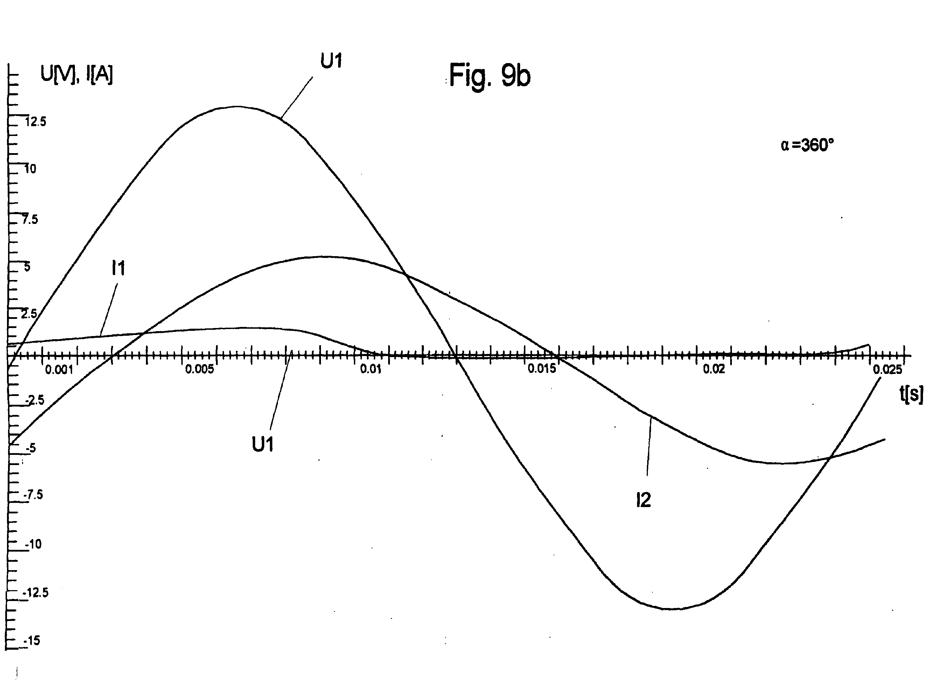

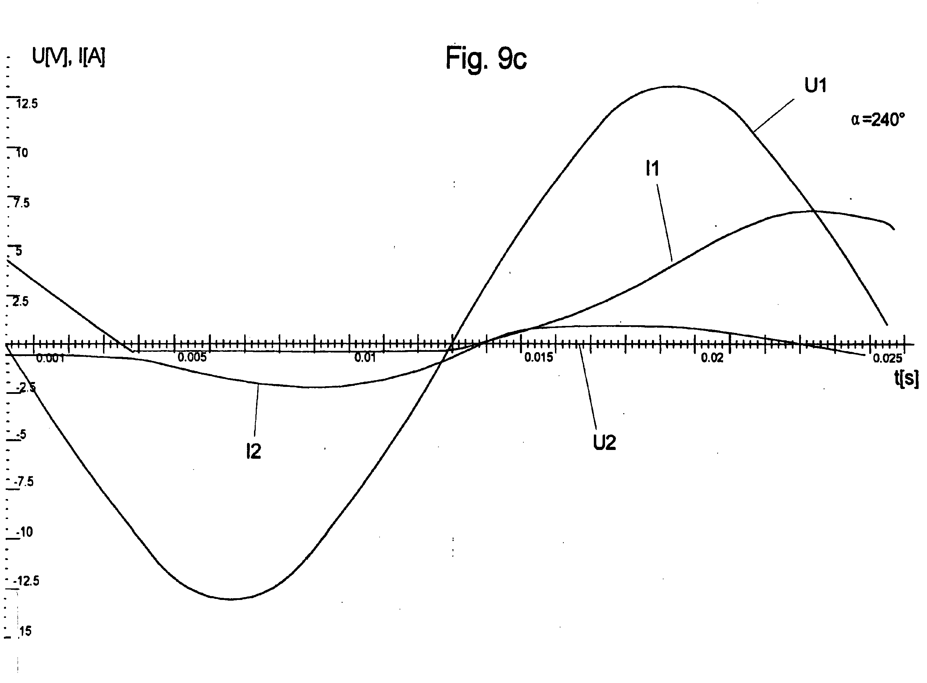

In entsprechender Weise ist anhand der Figuren 9a bis 9c erkennbar, dass der untere IGBT 26b des ersten Paares 26a, 26b (aus der ersten elektrischen Schaltung 21 des Umrichters 2) defekt ist, also nicht einschaltet. Denn hier nimmt der erste Phasenstrom l1 jeweils dann den Wert null an, wenn die zugehörige Spannung U1 bzw. U2 negativ ist, also der untere IGBT 26b eingeschaltet haben sollte.

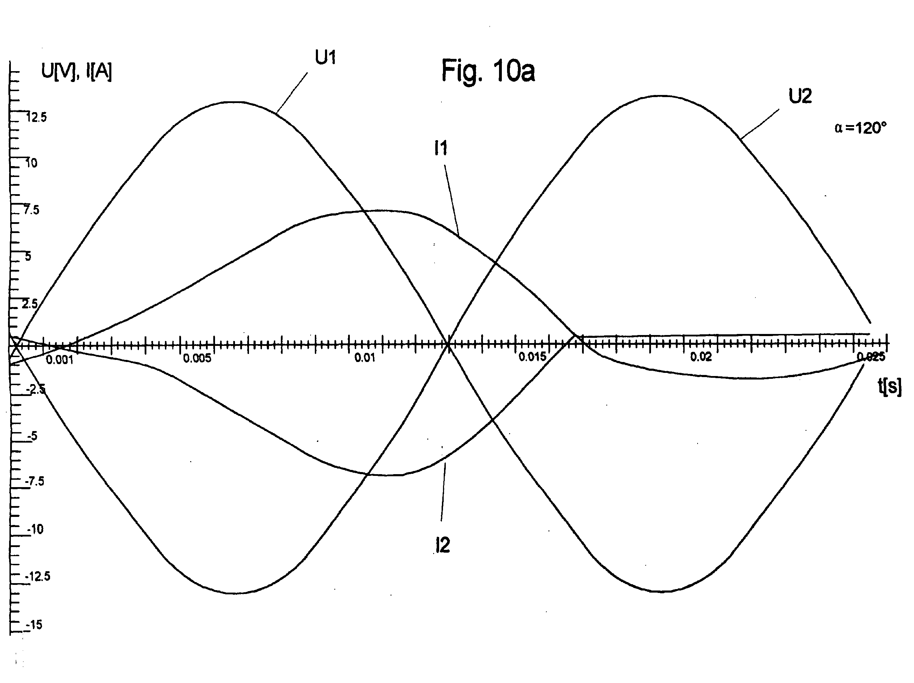

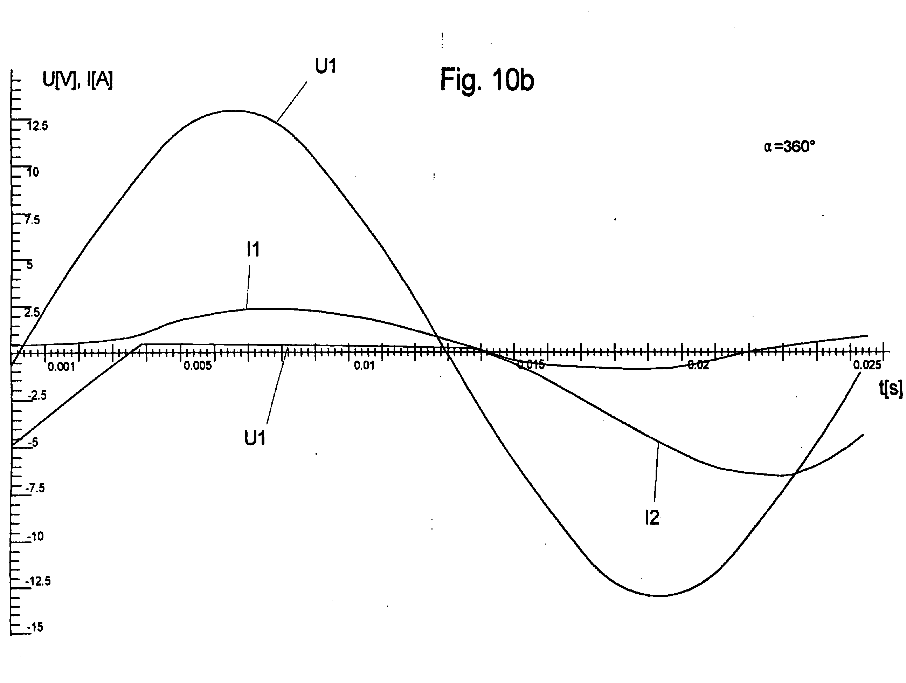

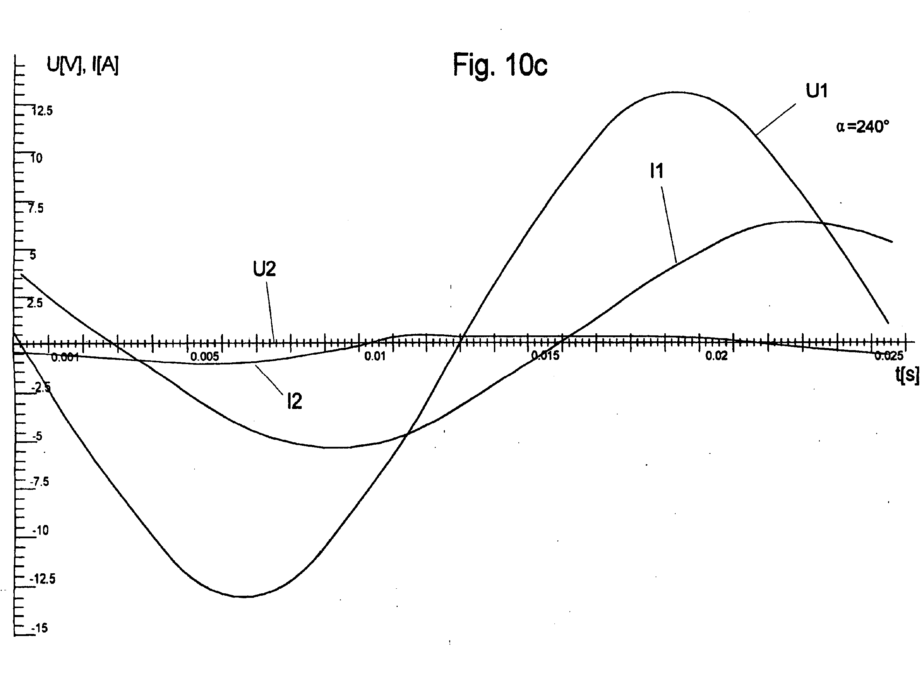

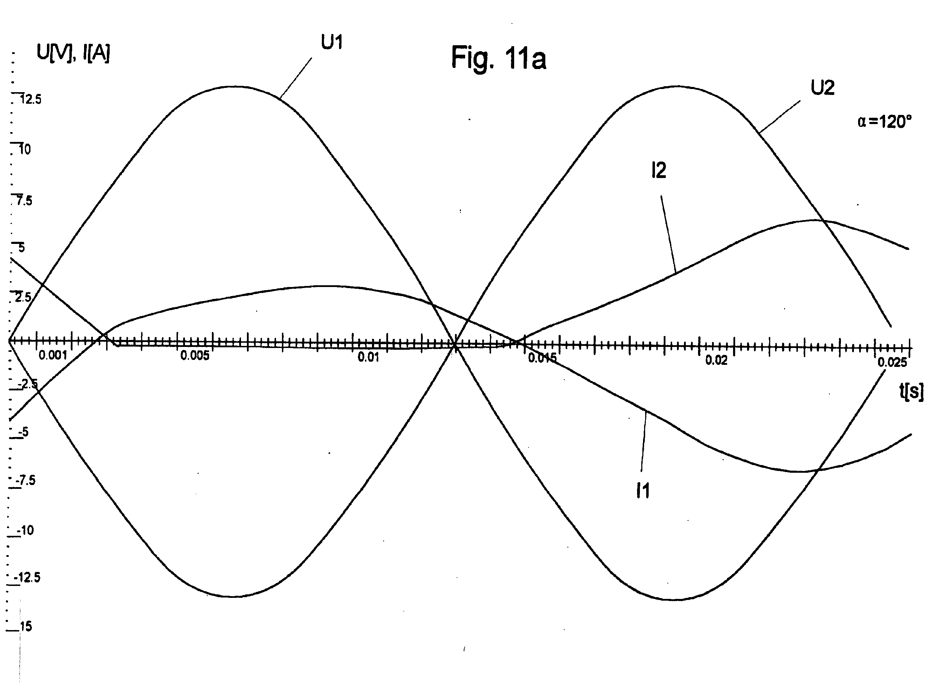

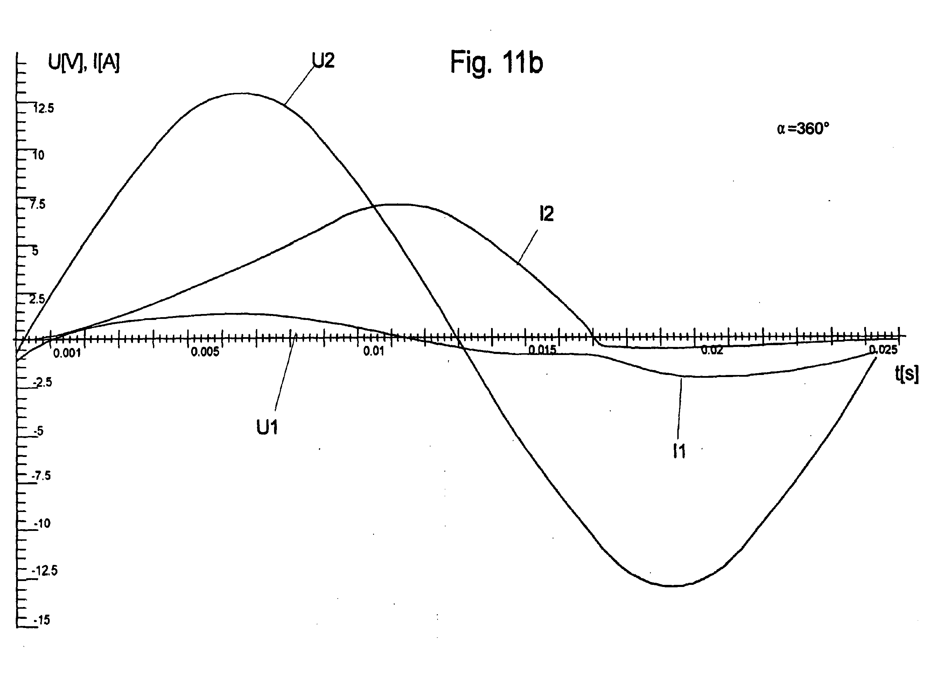

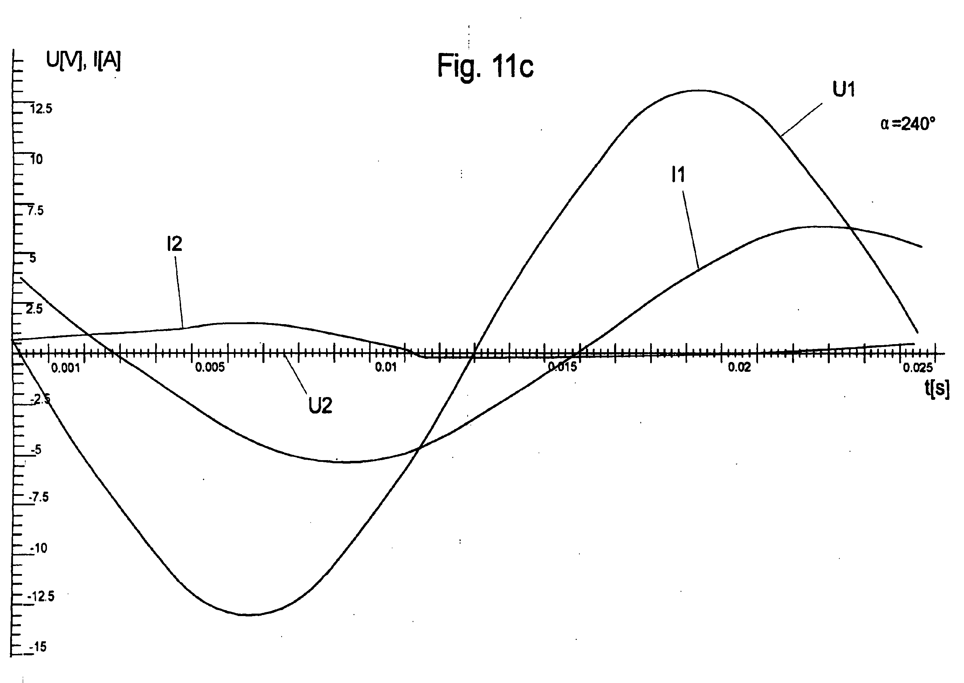

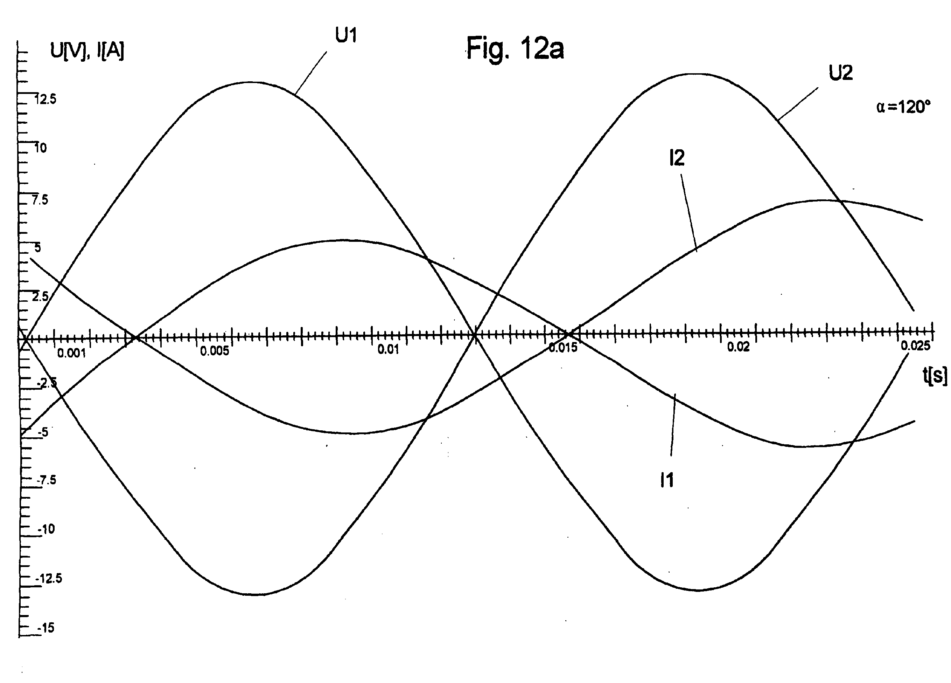

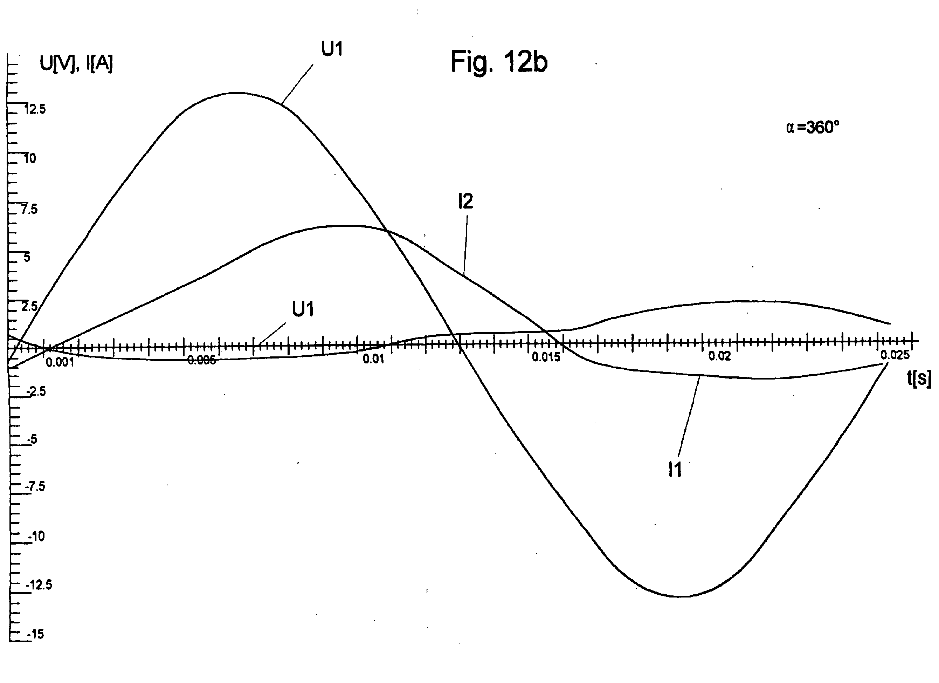

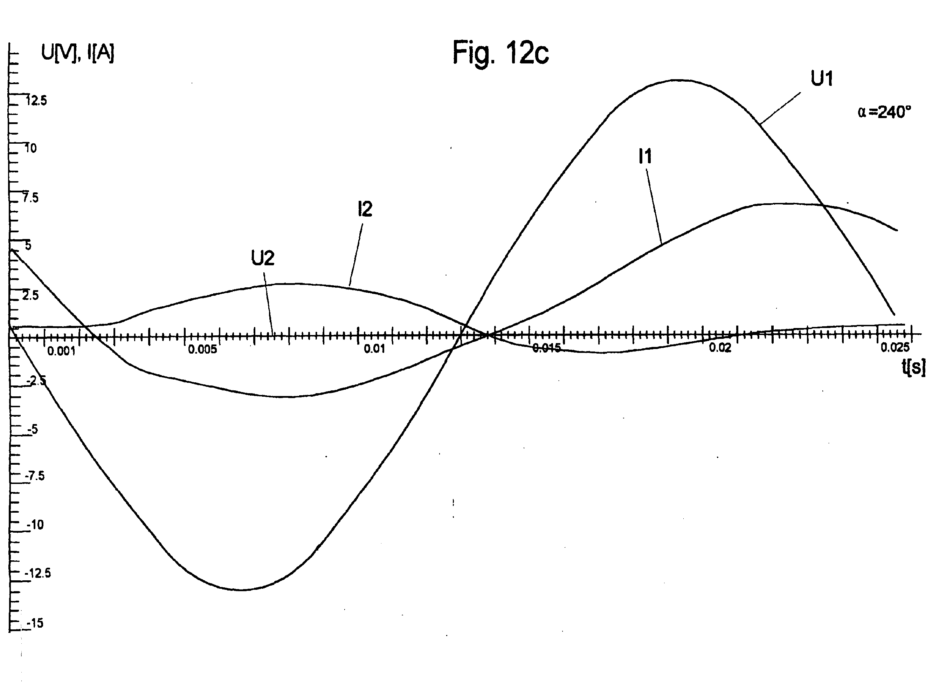

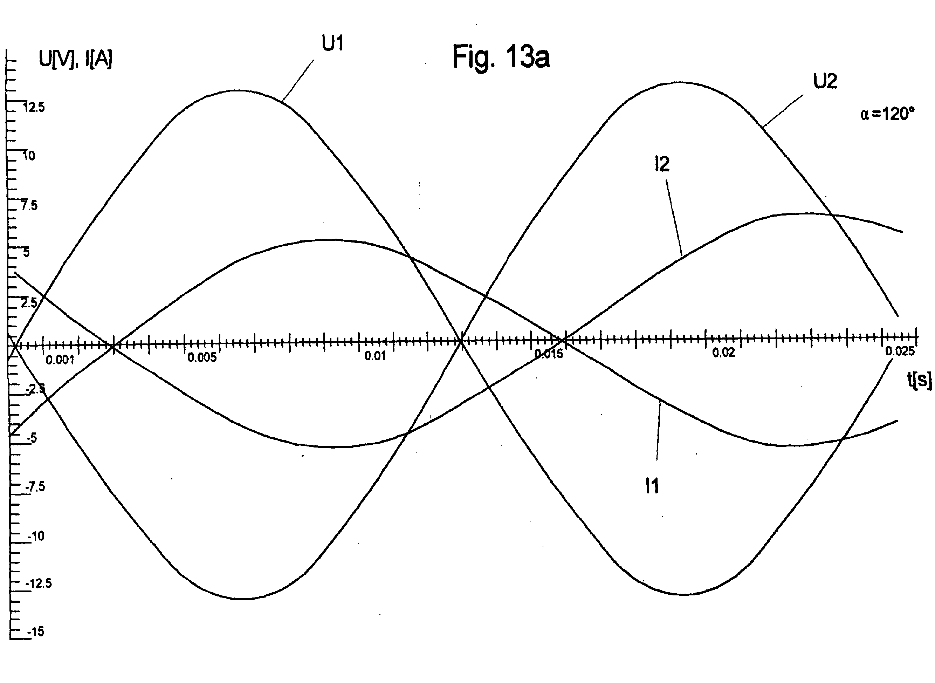

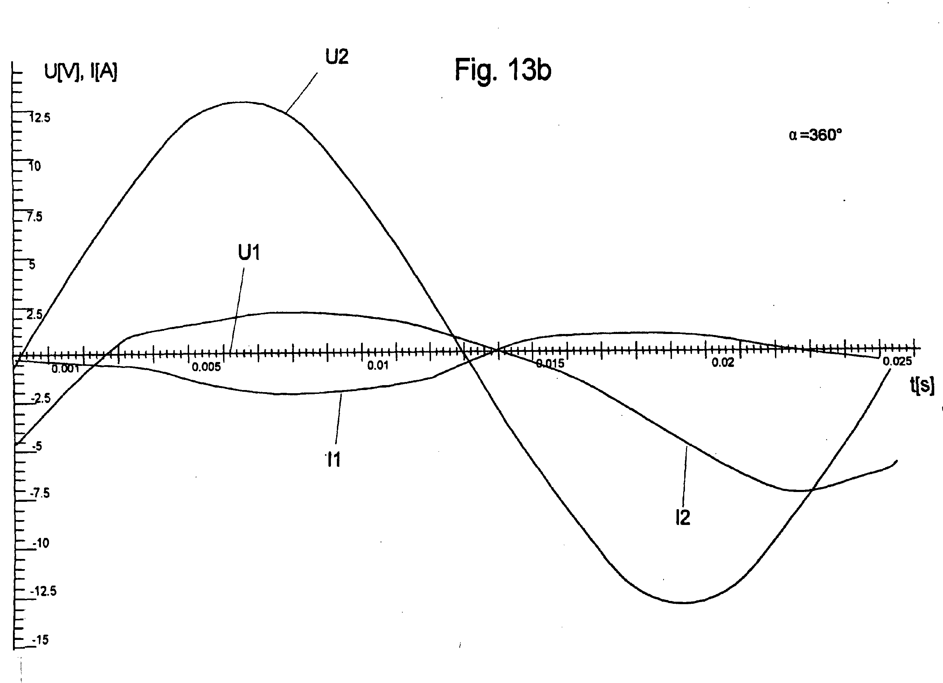

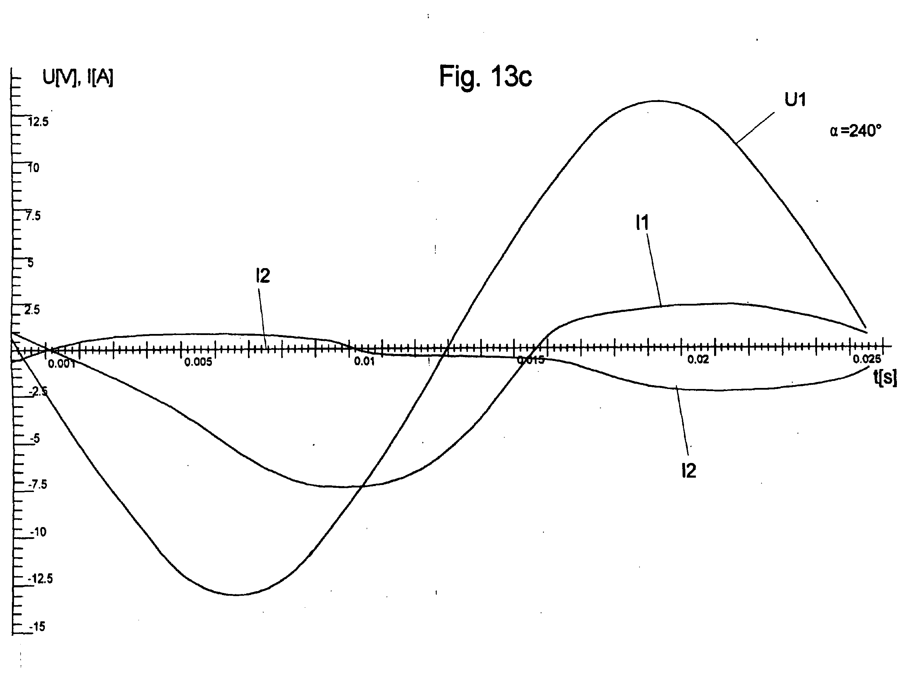

In entsprechender Weise lässt sich bei den Strom- und Spannungsverläufen in den Figuren 10a bis 10c, 11a bis 11c, 12a bis 12c und 13a bis 13c auf einen fehlerhaften oberen IGBT 27a des zweiten Paares 27a, 27b (Figuren 10a bis 10c), auf einen fehlerhaften unteren IGBT 27b des zweiten Paares 27a, 27b (Figuren 11a bis 11c), auf einen fehlerhaften oberen IGBT 28a des dritten Paares 28a, 28b (Figuren 12a bis 12c) bzw. auf einen fehlerhaften unteren IGBT 28b des dritten Paares 28a, 28b (Figuren 13a bis 13c) schließen.

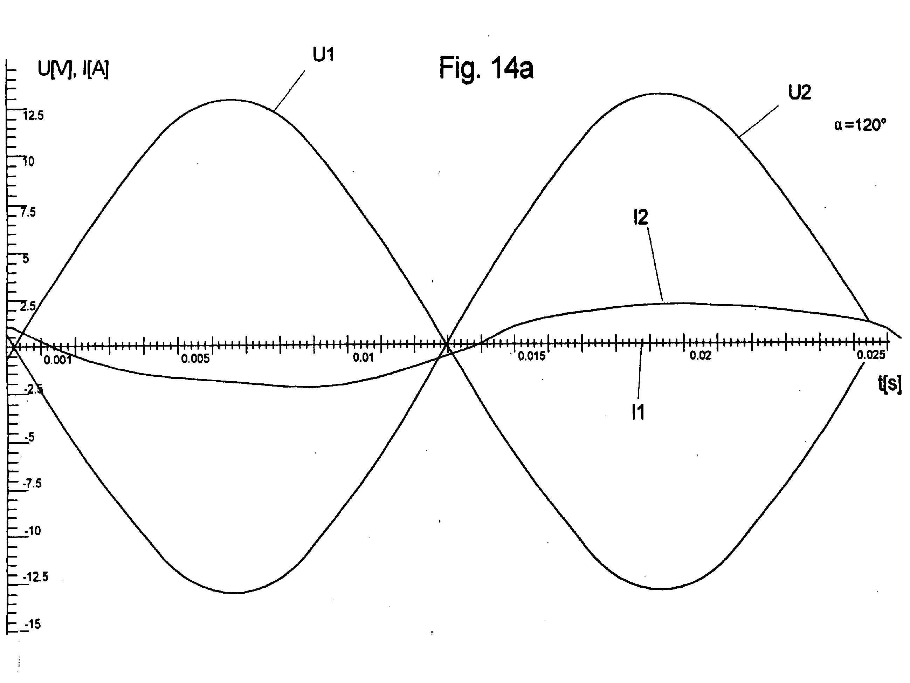

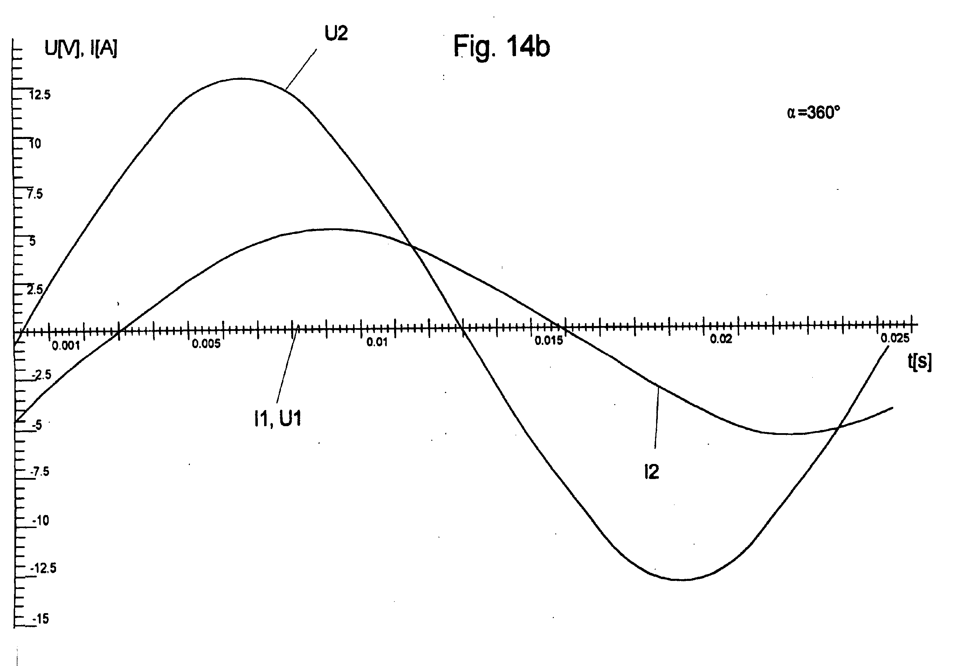

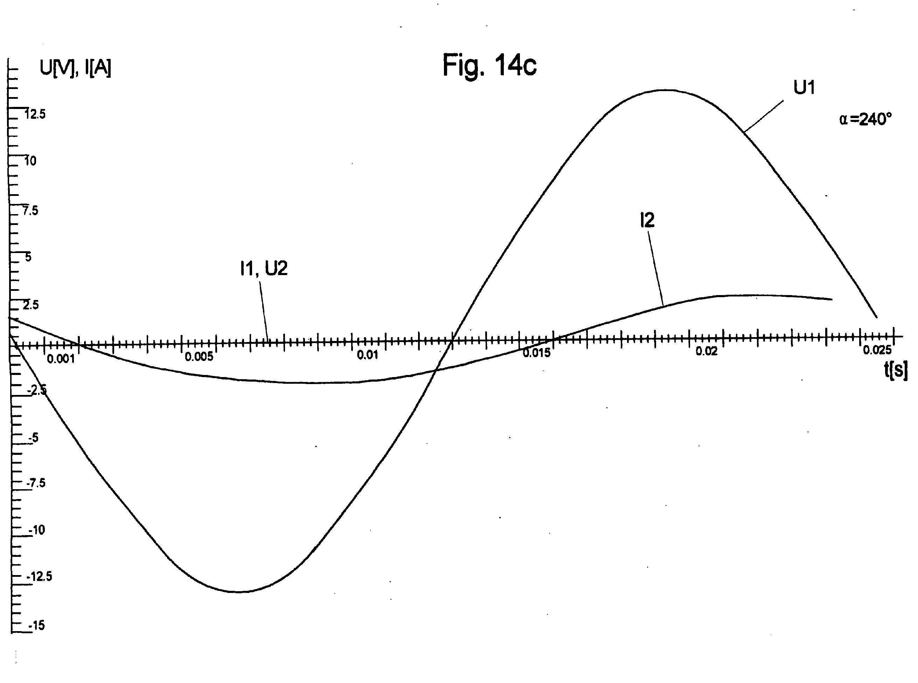

Die Figuren 14a bis 14c zeigen demgegenüber jeweils eine Strommessung bei den drei Stromwinkeln 120°, 240° sowie 360°, entsprechend den Erläuterungen zu den Figuren 7a bis 7c, bei einer Antriebseinrichtung gemäß Figur 1, bei der in der ersten Phase 11 des Antriebsmotors 1 eine Unterbrechung ("Phase offen") vorliegt. Diese kann eine Folge eines Leitungsbruches oder eines nicht ordnungsgemäß geschlossenen Kontaktes sein.

Als Folge hiervon ist der Phasenstrom l1 in der ersten Phase 11 des Antriebsmotors 1 stets gleich null, unabhängig von dem Wert der sinusförmig variierenden zugehörigen Spannung U1.

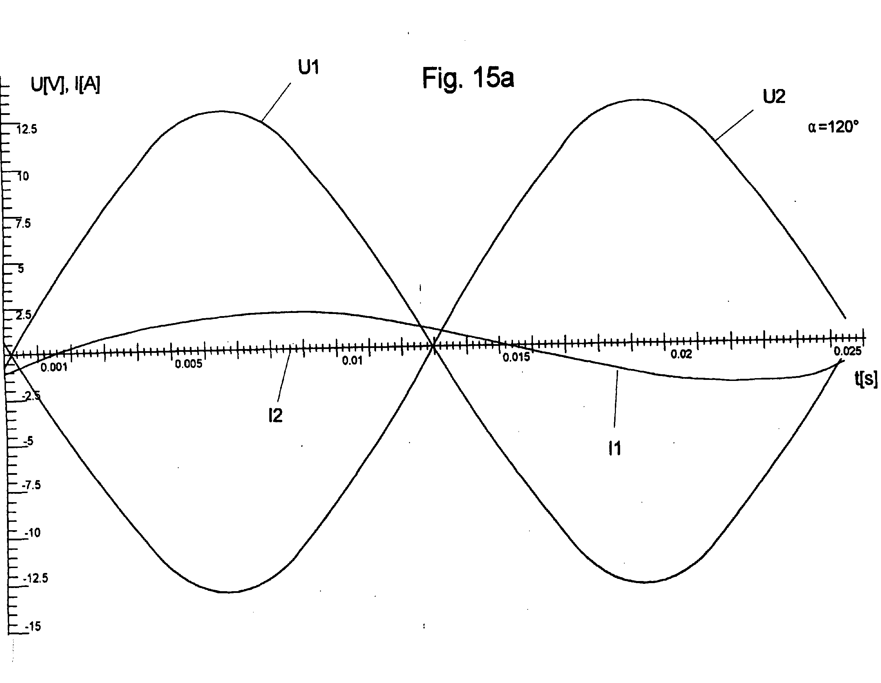

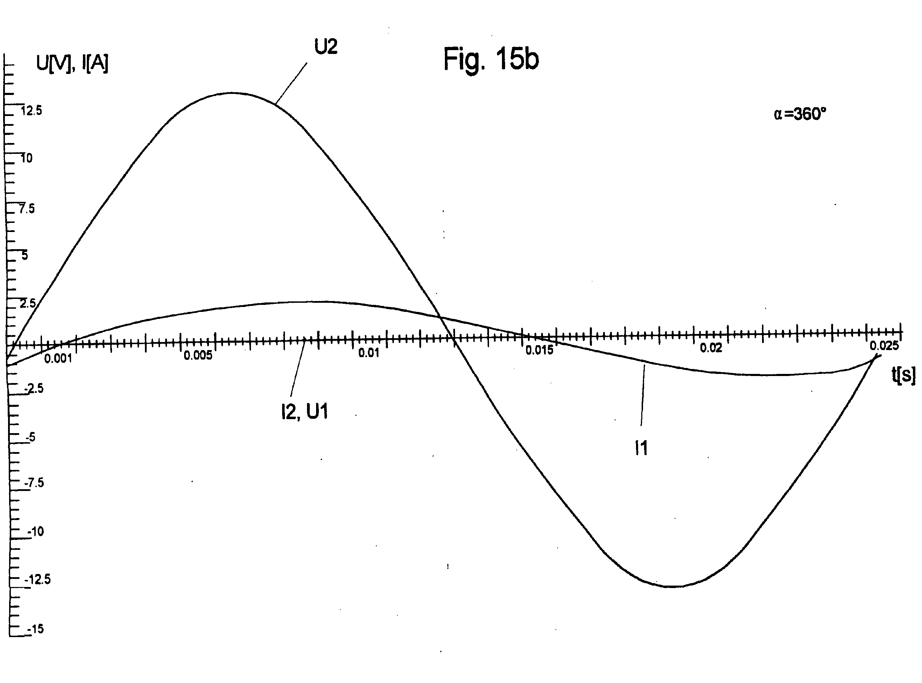

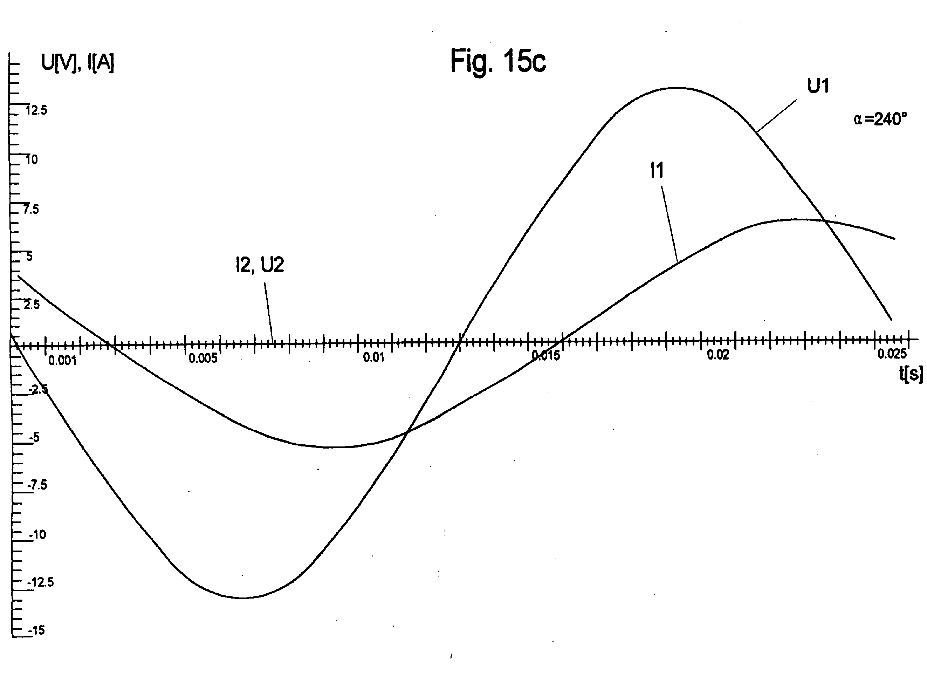

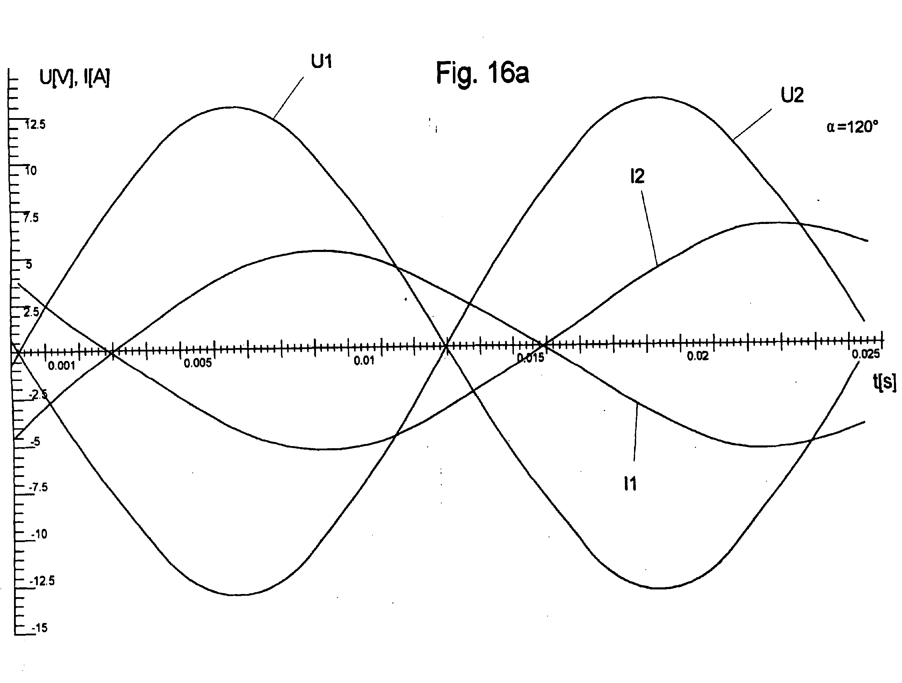

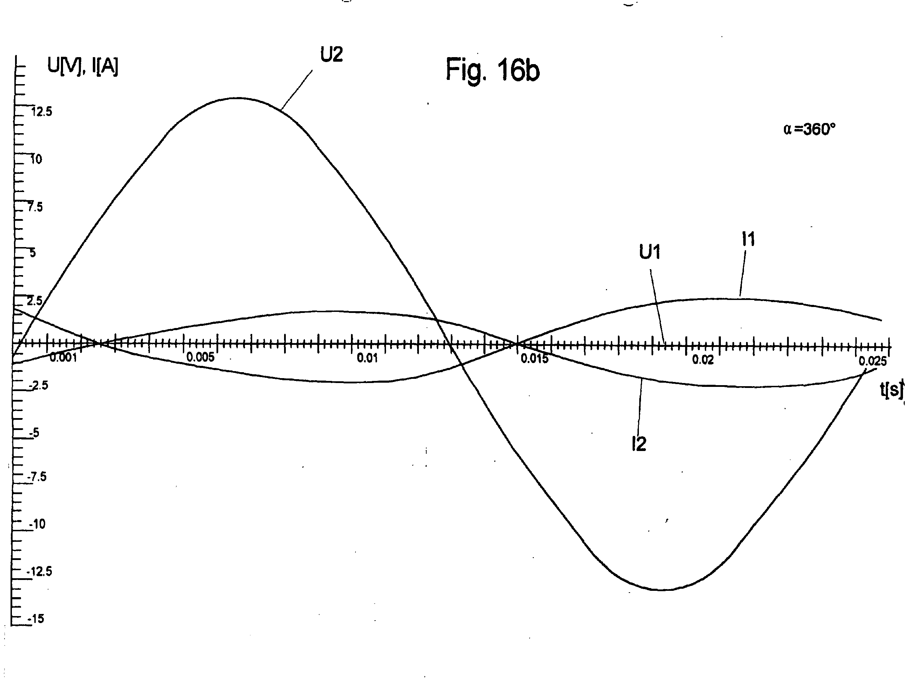

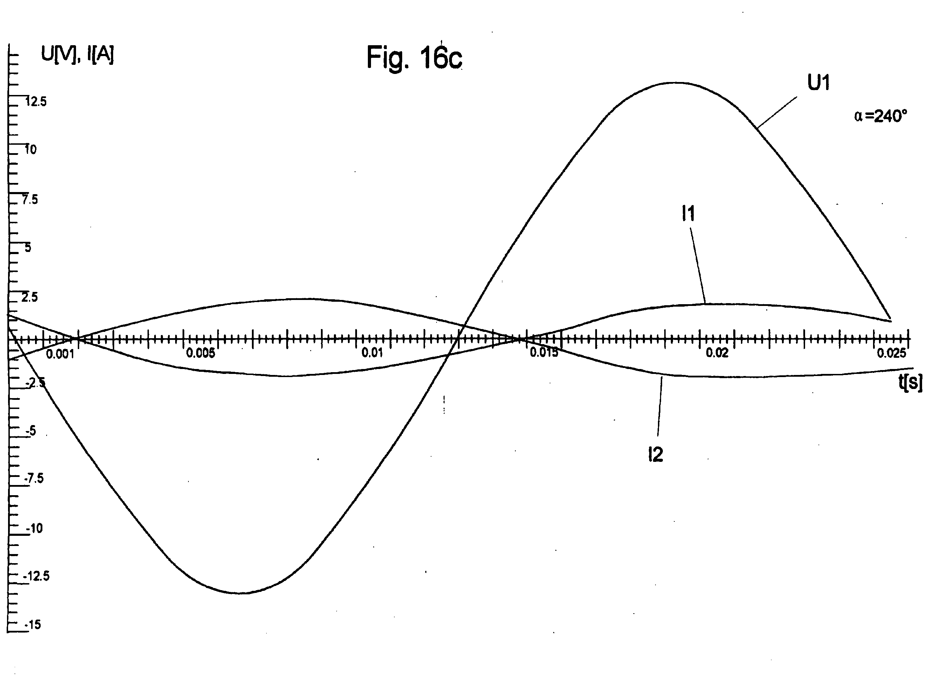

In entsprechender Weise ergibt eine Auswertung der Messergebnisse gemäß den Figuren 15a bis 15c bzw. gemäß den Figuren 16a bis 16c, dass in der zweiten Phase 12 bzw. der dritten Phase 13 des Antriebsmotors 1 eine Unterbrechung vorliegt, so dass der entsprechende Phasenstrom l2 stets gleich null ist (Figuren 15a bis 15c) bzw. die ersten und zweiten Phasenströme l1 und l2 sich selbst dann zu dem Wert null addieren, wenn lediglich eine der beiden zugeordneten Spannungen U1 oder U2 ungleich null ist, siehe Figuren 16b und 16c.

Zur konkreten, automatisierten (computergesteuerten) Auswertung der Messergebnisse, wie sie für bestimmte Fehlerfälle beispielhaft anhand der Figuren 7a bis 16c dargestellt sind, wird die Tatsache ausgenutzt, dass die Phasenströme l1, l2 den zugeordneten Spannungen U1 bzw. U2 hinterherlaufen. So werden zur Auswertung zunächst die Maxima, Minima und Nulldurchgänge der Spannungen U1 und U2 bestimmt, die den gemessenen Phasenströmen l1, l2 zugrunde liegen. Anschließend wird für jedes Spannungs-Maximum und den nachfolgenden Nulldurchgang der entsprechenden Spannung U1 oder U2 sowie das Spannungs-Minimum und den nachfolgenden Nulldurchgang jeweils das Maximum bzw. Minimum des zugehörigen Phasenstromes l1 bzw. l2 ermittelt. Es wird also jeweils das Maximum des Phasenstromes l1 bzw. l2 ermittelt, das zwischen einem Maximum der zugeordneten Spannung U1 oder U2 und dem nachfolgenden Nulldurchgang liegt, sowie das Minimum des jeweiligen Phasenstromes l1 bzw. l2, das zwischen einem Minimum und einem nachfolgenden Nulldurchgang der zugehörigen Spannung U1 oder U2 liegt.

Dies sei beispielhaft anhand Figur 7a erläutert, die die beiden Phasenströme l1 und l2 sowie die zugehörigen Spannungen U1, U2 für einen Stromwinkel von 120° bei einer Antriebseinrichtung zeigt, die keine zu detektierenden Fehler aufweist. Es ist erkennbar, dass zwischen dem Maximum und dem nachfolgenden Nulldurchgang der einen Spannung U1 ein Maximum des zugehörigen Phasenstromes l1 liegt. Entsprechend liegt zwischen dem Minimum des einen Phasenstromes U1 und seinem nachfolgenden Nulldurchgang wiederum ein Minimum des zugehörigen Phasenstromes I1. Entsprechendes gilt für die andere Spannung U2 und den zugehörigen Phasenstrom I2.

Aus jeder drei Messreihen, die bei den Stromwinkeln 120°, 240° sowie 360° aufgenommen werden, ergeben sich somit jeweils zwei Paare von Stromwerten für die Phasenströme l1 und l2, nämlich zwei Stromwerte für den ersten Phasenstrom l1 und zwei Stromwerte für den zweiten Phasenstrom l2. Denn aus jeder Halbperiode der zugehörigen Spannung U1 bzw. U2 wird jeweils ein zugehöriger Stromwert des entsprechenden Phasenstromes l1 bzw. l2 bestimmt.

Vergleicht man nun die Darstellung gemäß Figur 8a mit der Darstellung gemäß Figur 7a, so zeigt sich, dass aufgrund des fehlerhaften oberen IGBT 26a des ersten Paares 26a, 26b der erste Phasenstrom l1 zwischen dem Maximum und dem nachfolgenden Nulldurchgang der zugehörigen Spannung U1 kein eigenes Maximum annimmt. Der Phasenstrom l1 ist über den gesamten Bereich (bis auf Rauschen) im Wesentlichen gleich null. Das Fehlen des Strom-Maximums weist also darauf hin, dass sich der Phasenstrom 11 hier nicht entsprechend der zugrundeliegenden Spannung U1 verhält, was wiederum ein Hinweis auf einen nicht einschaltenden IGBT 26a ist.

Zur systematischen Auswertung der Messreihen der Phasenströme l1, l2 auf der Grundlage des vorstehend erläuterten Prinzips wird wie folgt vorgegangen:

Die ermittelten Strom-Maxima und Strom-Minima (die jeweils zwischen einem Maximum und einem Nulldurchgang bzw. einem Minimum und einem Nulldurchgang der zugrundeliegenden elektrischen Spannung auftreten) werden daraufhin bewertet, ob sie ein tatsächliches Strom-Maximum bzw. Strom-Minimum darstellen oder ob lediglich das Maximum bzw. Minimum eines Rauschens gemessen wurde, der Strom aber tatsächlich im Wesentlichen gleich null ist. Hierzu werden die Beträge der gemessenen Strom-Maxima bzw. Strom-Minima mit dem maximalen gemessenen Stromwert Imess verglichen, und zwar unter Verwendung eines Bewertungsfaktors k. Dieser kann beispielsweise den Wert k= 0.2 aufweisen. Die in der oben erläuterten Weise ermittelten Maxima und Minima der Phasenströme l1, l2 werden dann jeweils danach bewertet, ob sie vom Betrag her größer oder kleiner sind als das k-fache des größten überhaupt gemessenen Stromes Imess. Nur wenn ersteres der Fall ist, wird das Vorliegen eines echten Strom-Maximums bzw. -Minimums angenommen. Ansonsten wird davon ausgegangen, dass der entsprechende Strom im Wesentlichen gleich null ist und lediglich Rauschen gemessen wurde.

Für die Bildung einer systematisch auswertbaren Tabelle gelten dann folgende Formeln:
Wenn |l| > k*|lmess| & l > 0, dann wird dem entsprechenden Strom l der Wert "1" zugeordnet. (Der Strom l steht dabei wahlweise für die Messwerte des Phasenstromes l1 o-der l2.)
Falls |l| <= k*|lmess|, dann wird dem entsprechenden Strom l der Wert "0" zugeordnet.
Falls |l| > k*|lmess| & l < 0, dann wird dem entsprechenden Strom l der Wert "-1" zugeordnet.

Es werden also zum Detektieren eines Fehlers nicht die tatsächlich gemessenen Stromwerte unmittelbar ausgewertet, sondern es wird jeweils dem Stromverlauf zwischen einem Maximum der zugrundeliegenden Spannung und einem Nulldurchgang der zugrundeliegenden Spannung der Wert "1" oder "0" zugeordnet, wobei der Wert "1" bedeutet, dass in dem besagten Bereich ein Strom-Maximum aufgetreten ist und der Wert "0" bedeutet, dass der Strom in dem entsprechenden Bereich im Wesentlichen gleich null ist. In entsprechender Weise wird dem jeweils gemessenen Strom zwischen einem Spannungs-Minimum und dem nachfolgenden Nulldurchgang der Wert "-1" zugeordnet, wenn hier ein tatsächliches Minimum des entsprechenden Stromes aufgetreten ist, ansonsten der Wert "0". So lassen sich die Ergebnisse der Strommessungen in einer Tabelle darstellen, wobei jedem der betrachteten Strom-Winkel 120°, 240° sowie 360° jeweils vier Stromwerte zugeordnet sind, nämlich jeweils zwei Werte des ersten Phasenstromes l1 und zwei Werte des zweiten Phasenstromes l2. Diese Werte werden wiederum danach sortiert, ob sie den Bereich zwischen einem Maximum und einem nachfolgenden Nulldurchgang oder zwischen einem Minimum und einem nachfolgenden Nulldurchgang der zugehörigen Spannung repräsentieren.

Diese Tabelle lässt sich dann in gleicher Weise auswerten, wie weiter oben die tatsächlich gemessenen Stromverläufe anhand der Figuren 7a bis 15c ausgewertet worden sind. Dies wurde anhand der Figuren 7a und 8a bereits erläutert und gilt auch für die weiteren Figuren. Denn die obige Auswertung hat gezeigt, dass es für die Feststellung eines Fehlers nicht auf den gesamten gemessenen Stromverlauf ankommt, sondern lediglich darauf, ob der jeweils gemessene Phasenstrom in einem bestimmten Bereich der zugehörigen elektrischen Spannung größer als null, gleich null oder kleiner als null ist. Dies lässt sich mit dem zur Bildung der Tabelle angewandten Kriterium unter Bestimmung der Strom-Maxima bzw. -Minima erfassen.

Insbesondere lässt sich, wie anhand der Figuren 7a bis 15c demonstriert, unterscheiden, ob ein Fehler in einem IGBT vorliegt oder eine der Phasen 11, 12, 13 des Antriebsmotors 1 offen ist. Im letztgenannten Fall ist der zugehörige Phasen-Strom unabhängig von der zeitlich variierten Spannung stets gleich null, während im erstgenannten Fall der entsprechende Phasen-Strom nur dann gleich null ist, wenn er von dem fehlerhaften IGBT abhängt. Das fehlerhafte Verhalten eines IGBT kann dabei seine Ursache auch in der zugehörigen Ansteuerlogik haben.

Die besagten Fehler im Umrichter 2 einerseits und im Antriebsmotor 1 andererseits lassen sich auch von einem Defekt eines der beiden Stromsensoren 41, 42 ("Stomsensor hängt auf Vollausschlag") unterscheiden. Denn bei einem Defekt eines der Stromsensoren 41, 42 ist zu erwarten, dass der Stromsensor unabhängig von irgendeiner der Spannungen stets denselben Stromwert liefert.

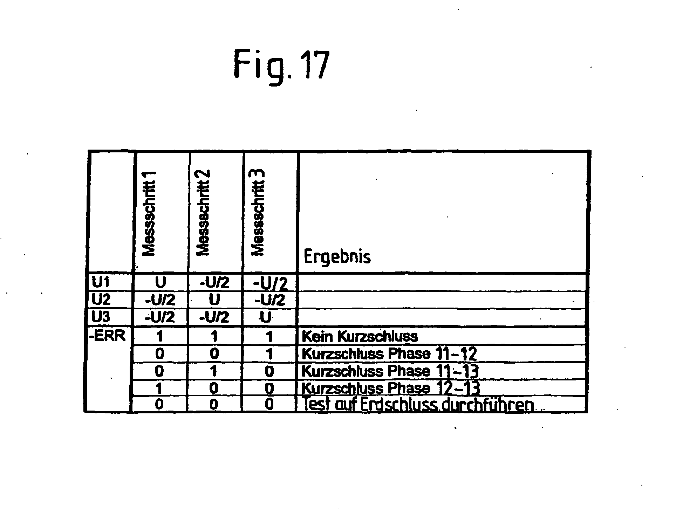

Es wird nun anhand der tabellarischen Darstellung in Figur 17 erläutert werden, wie der bei der Beschreibung des Gesamtverfahrens anhand des Flussdiagramms in Figur 2 erwähnte Test auf einen Kurzschluss zwischen zwei Phasen des Antriebsmotors 1 durchgeführt wird. Dieser Test wird immer dann durchgeführt, wenn bei den Messungen der Phasenströme l1, l2 ein Überstrom aufgetreten ist, vgl. Figur 2.

Zum Test auf Phasen-Kurzschluss werden insgesamt drei Strom-Messungen durchgeführt, und zwar bei den Stromwinkeln 90°, 210° sowie 330°. Bei diesen Stromwinkeln liegen jeweils zwei der Phasen 11, 12, 13 auf einem identischen Potential, während die dritte Phase auf einem hiervon abweichenden, anderen Potential liegt. An den beiden ersten Phasen liegt also ein übereinstimmender erster Spannungswert, z.B. -U/2, und an der dritten Phase ein hiervon abweichender anderer Spannungswert, z.B. U.

Wird bei einem der drei Messschritte ein Kurzschluss beobachtet, entsprechend einem Überstrom in mindestens einem der IGBTs, so kann dieser nicht zwischen den beiden Phasen vorliegen, die ein übereinstimmendes elektrisches Potential aufweist. Denn bei einem übereinstimmenden elektrischen Potential erzeugen selbst kurzgeschlossene Leitungen keinen Stromfluss. Eine entsprechende Entscheidungsmatrix ist in Figur 17 dargestellt.

In den drei Messschritten werden demnach die drei Spannungen U1, U2, U3 der Phasen 11, 12, 13 des Antriebsmotors 1 variiert, wie vorstehend dargelegt, wobei jeweils eine der Phasen auf das Potential "U" und die beiden anderen Phasen auf das Potential "-U/2" gelegt werden. In Abhängigkeit von der Verteilung der Werte "0" und "1" an der Fehlerausgabe "-ERR" lässt sich dann ermitteln, ob kein Kurzschluss vorliegt und ggf. welche beiden der drei Phasen 11, 12, 13 kurzgeschlossen sind.

Endet der Test auf Kurzschluss zwischen zwei Phasen 11, 12, 13 des Antriebsmotors 1 mit dem Ergebnis, dass bei allen drei Messschritten jeweils der Wert "0" an der Fehler-ausgabe "-ERR" anliegt, so wird gemäß Figur 2 überprüft, ob die Ursache für einen zuvor detektierten Überstrom in einem IGBT auf einen Erdschluss einer der Phasen 11, 12, 13 des Antriebsmotors 1 zurückzuführen ist. Alternativ kann ein Kurzschluss in einem IGBTs selbst vorliegen.

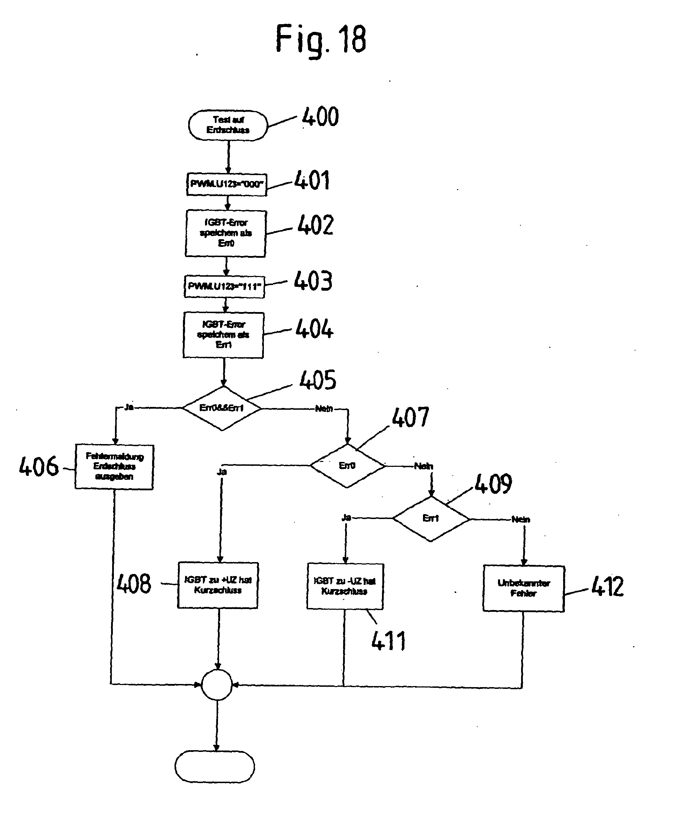

Zur Durchführung des Testes 400 auf Erdschluss werden gemäß Figur 18 zunächst alle PWM-Signale PWM1, PWM2 und PWM3 fest auf den Wert "0" gelegt (401). Dies bedeutet, dass bei den drei IGBT-Paaren des Umrichters 2 jeweils der untere IGBT 26b, 27b und 28b eingeschaltet ist. Eine hierbei auftretende Abschaltung 402 wegen Überstromes wird als "Err0" gespeichert. Anschließend werden die drei PWM-Signale PWM1, PWM2, PWM3 jeweils auf den Wert "1" gelegt, so dass die oberen IGBTs 26a, 27a und 28a eingeschaltet sind (403). Ein hierbei gemessener Überstrom wird im nächsten Schritt 404 als "Err1" gespeichert.

Nachfolgend wird in einem weiteren Schritt 405 überprüft, ob sowohl der Fehler "Err0" als auch der Fehler "Err1" vorliegt. In diesem Fall wird eine Fehlermeldung 406 ausgegeben, wonach ein Erdschluss vorliegt. Denn beim Vorliegen eines Erdschlusses tritt in der entsprechenden Phase 11, 12 oder 13 des Antriebsmotors 1 ein Überstrom unabhängig davon auf, welcher der beiden jeweils zugeordneten IGBTs eingeschaltet ist.

Wird demgegenüber die Abfrage bei 405 verneint, so wird in zwei weiteren Schritten 407 und 409 geprüft, ob einer der beiden Fehler "Err0" oder "Err1" vorliegt. Im erstgenannten Fall liegt ein Kurzschluss in einem der oberen IGBTs 26a, 27a, 28a vor, mit denen die Motorphasen U1, U2 und U3 auf die obere Zwischenkreisspannung Uz/2 geschaltet werden können. Im anderen Fall liegt ein Kurzschluss in einem der unteren IGBTs 26b, 27b, 28b vor, mit denen die untere Zwischenkreisspannung -Uz/2 auf die jeweilige Motorphase U1, U2 bzw. U3 gelegt werden kann. Der Grund hierfür liegt darin, dass bei einem Kurzschluss innerhalb eines IGBT eine Abschaltung wegen eines Überstromes genau dann erfolgt, wenn der jeweils andere IGBT desselben IGBT-Paares eingeschaltet ist.

Die Detektion eines Kurzschlusses in einem der oberen oder der unteren IGBTs führt zu einer entsprechenden Fehlermeldung 408 bzw. 411. Eine separate Fehlermeldung 412 erfolgt, wenn bei der Durchführung des Testes weder ein Erdschluss noch ein Kurzschluss in einem der IGBTs detektiert worden ist. Dies kann auch auf einen Fehler bei der Ausführung des Testes selbst hindeuten.

## Patentansprüche

1. Verfahren zur Fehlererkennung bei einer Antriebseinrichtung mit einem Mehrphasen-Elektromotor (1) einem dem Elektromotor vorgeschalteten Stromrichter (2), und einem Regler (3), den PWM-Signale erzeugt, wobei der Stromrichter (2), die Spannung an den einzelnen Phasen des Elektromotors (1) steuert und die Phasenströme in den Phasen des Elektromotors jeweils periodisch verlaufen, wobei die Eingangssignale (PWM.U1, PWM.U2, PWM.U3) des Stromrichters in Abhängigkeit, von Ausgangssignalen (PWM1, PWM2, PWM3) des Reglers (3) gebildet werden **dadurch gekennzeichnet dass** zur Fehlererkennung mehrere Phasenströme (I1, I2) des Elektromotors an einem vorgegebenen Punkt der jeweiligen Periode bei gleichzeitiger Variation der zugehörigen Spannungen (U1, U2) an den entsprechenden Phasen (11, 12) des Elektromotors (1) gemessen werden und Messwerte der Phasenströme (I1, I2) in Abhängigkeit von der Spannung (U1, U2) an der entsprechenden Phase (11, 12) des Elektromotors (1) ausgewertet werden, wobei
- durch Auswertung der Phasenströme (I1, I2) in Abhängigkeit von der zugehörigen Spannung (U1, U2) zwischen einem Fehler in dem Stromrichter (2) und einer Unterbrechung des Stromflusses in einer Phase (11, 12, 13) des Elektromotors (1) unterschieden wird, indem bei einer Unterbrechung in einer Phase (11, 12, 13) des Elektromotors (1) der entsprechende Phasenstrom (I1, I2, I3) unabhängig von dem Wert der zugehörigen Spannung (U1, U2, U3) gleich null ist und bei einem Fehler in einem Stromrichterventil (26a bis 28b)des Stromrichters (2) der entsprechende Phasenstrom (I1, I2, I3) nur für einen Teilbereich der Werte der zugehörigen Spannung (U1, U2, U3) gleich null ist, und wobei
- die Ausgangssignale (PWM1, PWM2, PWM3) des Reglers (3) an der Schnittstelle zwischen Regler (3) und Stromrichter (2) im Hinblick auf Fehler in den Signalen mittels einer Auswerteschaltung (5) überprüft werden.

2. Verfahren nach Anspruch 1, **dadurch gekennzeichnet, dass** mindestens einer der Phasenströme (I1, I2, I3) an dem Punkt der Periode, an dem eine Messung durchgeführt wird, gleich null ist.

3. Verfahren nach einem der vorhergehenden Ansprüche, **dadurch gekennzeichnet, dass** die einzelnen Phasenströme (I1, I2, I3) um einen konstanten Betrag zueinander phasenverschoben sind und die Messung von Phasenströmen (I1, I2.) an einem konstanten Punkt (120 DEG , 240 DEG , 360 DEG) einer der Perioden der Phasenströme (I1, I2, I3) erfolgt.

4. Verfahren nach einem der vorhergehenden Ansprüche, **dadurch gekennzeichnet, dass** das Verhältnis der Spannungen (U1, U2), die während der jeweiligen Strommessung ungleich null sind, während der Messung konstant bleibt, und dass deren Summe während der Messung gleich null ist..

5. Verfahren nach einem der vorhergehenden Ansprüche, **dadurch gekennzeichnet, dass** mehrere Messungen der Phasenströme (I1, I2) zur Fehlererkennung an jeweils einem vorgegebenen Punkt der Periode durchgeführt werden.

6. Verfahren nach Anspruch 5, **dadurch gekennzeichnet, dass** die Anzahl der Strommessungen an unterschiedlichen Punkten der Periode der Anzahl der Phasen (11, 12, 13) des Elektromotors (1) entspricht.

7. Verfahren nach Anspruch 2 und Anspruch 6, **dadurch gekennzeichnet, dass** bei jeder der Messungen ein anderer der Phasenströme (I1, I2, I3) gleich null ist.

8. Verfahren nach einem der vorhergehenden Ansprüche, **dadurch gekennzeichnet, dass** zur Auswertung der gemessenen Phasenströme (I1, I2) die Messwerte anhand des Verlaufs der zugehörigen Spannungen (U1, U2) bestimmbaren Punkten des jeweiligen Stromverlaufs ausgewertet werden.

9. Verfahren nach einem der vorhergehenden Ansprüche, **dadurch gekennzeichnet, dass** zur Auswertung der gemessenen Phasenströme (I1, I2) die Messwerte in tabellarischer Form abgelegt werden.

10. Verfahren nach einem der vorhergehenden Ansprüche, **dadurch gekennzeichnet, dass** das Verhalten eines der Phasenströme (I3) aus den Messewerten der anderen Phasenströme (I1, I2) bestimmt wird.

11. Verfahren nach Anspruch 1, **dadurch gekennzeichnet, dass** die Ausgangssignale (PWM1, PWM2, PWM3) des Reglers (3) nach einem vorgegebenen Muster variiert werden und dass in Abhängigkeit hiervon eingangsseitig an dem Stromrichter (2) erzeugte Spannungssignale (PWM.U1. PWM.U2, PWM.U3) gemessen und ausgewertet werden.

12. Verfahren nach Anspruch 11, **dadurch gekennzeichnet, dass** ein Fehler als erkannt gilt, wenn ein aufgrund der Ausgangssignale (PWM1, PWM2, PWM3) des Reglers (3) erwartetes Spannungssignal (PWM.U1, PWM.U2, PWM.U3) nicht auftritt.

13. Verfahren nach Anspruch 11 oder 12, **dadurch gekennzeichnet, dass** zur Auswertung der Spannungssignale (PWM.U1, PWM.U2, PWM.U3) verschiedene, durch die Ausgangssignale (PWM1, PWM2, PWM3) des Reglers (3) erzeugte eingangsseitige Spannungssignale (PWM.U1, PWM.U2, PWM.U3) des Stromrichters (2) miteinander verknüpft werden.

14. Verfahren nach Anspruch 13, **dadurch gekennzeichnet, dass** die Spannungssignale (PWM.U1, PWM.U2, PWM.U3) durch mindestens ein logisches Gatter (56, 57), insbesondere in Form eines EXOR-Gatters, miteinander verknüpft werden.

15. Verfahren nach einem der vorhergehenden Ansprüche, **dadurch gekennzeichnet, dass** bei Auftreten eines Überstromes während der Messung der Phasenströme (I1, I2, I3) zusätzlich geprüft wird, ob zwischen zwei Phasen (11, 12, 13) des Elektromotors (1) ein Kurzschluss vorliegt.

16. Verfahren nach Anspruch 15, **dadurch gekennzeichnet, dass** die Prüfung auf Kurzschluss dann erfolgt, wenn ein Überstrom in einem Stromrichterventil (26a bis 28b) des Stromrichters (2) aufgetreten ist.

17. Verfahren nach Anspruch 15 oder 16, **dadurch gekennzeichnet, dass** zur Prüfung auf Kurzschluss jeweils zwei Phasen (11, 12; 11, 13; 12, 13) des Elektromotors (1) auf das gleiche elektrische Potential (-U/2) gelegt werden.

18. Verfahren nach Anspruch 17, **dadurch gekennzeichnet, dass** nacheinander jeweils unterschiedliche Phasen (11, 12; 11, 13; 12, 13) des Elektromotors (1) auf das gleiche elektrische Potential (-U/2) gelegt werden, um durch Auswertung der hierbei auftretenden Ströme festzustellen, zwischen welchen Phasen ein Kurzschluss vorliegt.

19. Verfahren nach einem der vorhergehenden Ansprüche, **dadurch gekennzeichnet, dass** bei Vorliegen eines Überstromes in einem Stromrichterventil (26a bis 28b) des Stromrichters (2) geprüft wird, ob bei einer der Phasen (11, 12, 13) des Elektromotors (1) ein Erdschluss vorliegt.

20. Verfahren nach Anspruch 19, **dadurch gekennzeichnet, dass** zur Prüfung auf Erdschluss die den einzelnen Phasen (11, 12, 13) des Elektromotors (1) vorgeschalteten elektrischen Schaltungen (21, 22, 23) des Stromrichters (2) jeweils mit identischen Eingangssignalen ("0" oder "1") beaufschlagt werden.

21. Verfahren nach Anspruch 19 oder 20, **dadurch gekennzeichnet, dass** zur Durchführung des Tests auf Erdschluss die elektrischen Spannungen (U1, U2, U3) an den drei Phasen (11, 12, 13) des Elektromotors (1) auf identische Werte eingestellt werden.

22. Verfahren nach einem der vorhergehenden Ansprüche, **dadurch gekennzeichnet, dass** der Mehrphasen-Elektromotor (1) als Dreiphasen-Drehstrommotor ausgebildet ist.

## Claims

1. A method for error recognition in a drive unit comprising a multi-phase electric motor (1), a power converter (2) connected upstream of the electric motor and a control unit (3), which generates PWM signals, wherein the power converter (2) controls the voltage at the individual phases of the electric motor (1) and the phase currents run in each case periodically in the phases of the electric motor, wherein the input signals (PWM.U1, PWM.U2, PWM.U3) of the power converter are formed as a function of output signals (PWM1, PWM2, PWM3) of the control unit (3), **characterized in that** a plurality of phase currents (I1, I2) of the electric motor are measured at a predetermined point of the respective period in response to a simultaneous variation of the corresponding voltages (U1, U2) at the corresponding phases (11, 12) of the electric motor (1) for the purpose of error recognition and the measuring values of the phase currents (I1, I2) are evaluated as a function of the voltage (U1, U2) at the corresponding phase (11, 12) of the electric motor (1), wherein
- a differentiation is made between an error in the power converter (2) and an interruption of the current flow in a phase (11, 12, 13) of the electric motor (1) by means of evaluating the phase currents (I1, I2) as a function of the corresponding voltage (U1, U2) **in that** the corresponding phase current (I1, I2, I3), independent on the value of the corresponding voltage (U1, U2, U3), equals zero in response to an interruption in a phase (11, 12, 13) of the electric motor (1) and the corresponding phase current (I1, I2, I3) equals zero only for a partial area of the values of the corresponding voltage (U1, U2, U3) in response to an error in a power converter valve (26a to 28b) of the power converter (2) and wherein
- the output signals (PWM1, PWM2, PWM3) of the control unit (3) are checked by means of an evaluation circuit (5) at the interface between control unit (3) and power converter (2) with reference to errors in the signals.

2. The method according to claim 1, **characterized in that** at least one of the phase currents (I1, I2, I3) equals zero at the point of the period, at which a measurement is performed.

3. The method according to one of the preceding claims, **characterized in that** the individual phase currents (I1, I2, I3) are phase-shifted to one another by a constant amount and the measurement of phase currents (I1, I2) is performed at a constant point (120 DEG, 240 DEG, 360 DEG) of one of the periods of the phase currents (I1, I2, I3).

4. The method according to one of the preceding claims, **characterized in that** the ratio of the voltages (U1, U2), which equal zero during the respective current measurement, remains constant during the measurement and that the sum thereof equals zero during the measurement.

5. The method according to one of the preceding claims, **characterized in that** a plurality of measurements of the phase currents (I1, I2) are performed in each case at a predetermined point of the period for the purpose of error recognition.

6. The method according to claim 5, **characterized in that** the number of the current measurements at different points of the period corresponds to the number of the phases (11, 12, 13) of the electric motor (1).

7. The method according to claim 2 and claim 6, **characterized in that** a different one of the phase currents (I1, I2, I3) equals zero in response to each of the measurements.

8. The method according to one of the preceding claims, **characterized in that** the measuring values are evaluated by means of the course of the definable points of the respective flow of current of the corresponding voltages (U1, U2) for the purpose of evaluating the measured phase currents (I1, I2).

9. The method according to one of the preceding claims, **characterized in that** the measuring values are stored in table form for the purpose of evaluating the measured phase currents (I1, I2) .

10. The method according to one of the preceding claims, **characterized in that** the behavior of one of the phase currents (I3) is determined from the measuring values of the other phase currents (I1, I2).

11. The method according to claim 1, **characterized in that** the output signals (PWM1, PWM2, PWM3) of the control unit (3) are varied according to a predetermined pattern and that voltage signals (PWM.U1, PWM.U2, PWM.U3) generated at the power converter (2) at the input side are measured and evaluated as a function thereof.

12. The method according to claim 11, **characterized in that** an error counts as having been recognized when a voltage signal (PWM.U1, PWM.U2, PWM.U3), which is expected due to the output signals (PWM1, PWM2, PWM3) of the control unit (3), does not appear.

13. The method according to claim 11 or 12, **characterized in that** different voltage signals (PWM.U1, PWM.U2, PWM.U3) of the power converter (2), which are generated at the input side by means of the output signals (PWM1, PWM2, PWM3) of the control unit (3), are linked with one another for the purpose of evaluating the voltage signals (PWM.U1, PWM.U2, PWM.U3).

14. The method according to claim 13, **characterized in that** the voltage signals (PWM.U1, PWM.U2, PWM.U3) are linked with one another by means of at least one logical gate (56, 57), in particular in the form of an EXOR gate.

15. The method according to one of the preceding claims, **characterized in that** an additional check is made in response to the appearance of an overcurrent during the measurement of the phase currents (I1, I2, I3) as to whether a short circuit is present between two phases (11, 12, 13) of the electric motor (1).

16. The method according to claim 15, **characterized in that** the check for a short circuit is performed when an overcurrent has appeared in a power converter valve (26a to 28b) of the power converter (2).

17. The method according to claim 15 or 16, **characterized in that** two phases (11, 12; 11, 13; 12, 13) of the electric motor (1) are in each: case connected to the same electric potential (-U/2) for the purpose of checking for a short circuit.

18. The method according to claim 17, **characterized in that** different phases (11, 12; 11, 13; 12, 13) of the electric motor (1) are in each case consecutively connected to the same electric potential (-U/2) so as to determine between which phases a short circuit is present by means of evaluating the currents, which appear in this connection.

19. The method according to one of the preceding claims, **characterized in that** a check is made as to whether a ground fault is present in one of the phases (11, 12, 13) of the electric motor (1) in response to the presence of an overcurrent in a power converter valve (26a to 28b) of the power converter (2).

20. The method according to claim 19, **characterized in that** identical input signals ("0" or "1") are in each case applied to electric circuits (21, 22, 23) of the power converter (2), which are connected upstream of the individual phases (11, 12, 13) of the electric motor (1) for the purpose of checking for ground fault.

21. The method according to claim 19 or 20, **characterized in that** the electric voltages (U1, U2, U3) at the three phases (11, 12, 13) of the electric motor (1) are set to identical values for the purpose of performing the test for ground fault.

22. The method according to one of the preceding claims, **characterized in that** the multi-phase electric motor (1) is embodied as a three-phase AC motor.

## Revendications

1. Procédé pour la reconnaissance d'erreurs dans un dispositif d'entraînement avec un moteur électrique polyphasé (1), un convertisseur (2) connecté en amont du moteur électrique et un régulateur (3) produisant des signaux PWM, le convertisseur dirigeant la tension vers les différentes phases du moteur électrique (1) et les courants de phase passent de façon périodique dans les phases du moteur électrique, les signaux d'entrée (PWM.U1, PWM.U2, PWM.U3) du convertisseur étant formés en fonction de signaux de sortie (PWM1, PWM2, PWM3) du régulateur (3), **caractérisé en ce que** pour la reconnaissance d'erreurs, plusieurs courants de phase (11, 12) du moteur électrique (1) sont mesurés, en un point prédéterminé de la période respective, avec une variation simultanée des tensions (U1, U2) correspondantes dans les différentes phases (11, 12) du moteur électrique (1), et des valeurs de mesure des courants de phase (11, 12) sont estimées en fonction de la tension (U1, U2) dans les différentes phases (11, 22) du moteur électrique (1), dans lequel
- l'estimation des courants de phase (11, 12) en fonction de la tension correspondante (U1, U2) permet de savoir s'il s'agit d'une erreur dans le convertisseur (2) ou d'une interruption du flux de courant dans une phase (11, 12, 13) du moteur électrique (1), en supposant que lors d'une interruption dans une phase (11, lé, 13) du moteur électrique (1), le courant de phase (11, 12, 13) correspondant est égal à zéro indépendamment de la valeur de la tension correspondante (U1, U2, U3), et lors d'une erreur au niveau d'une soupape de convertisseur (26a à 28b) du convertisseur (2), le courant de phase (11, 12, 13) correspondant n'est égal à zéro que pour une certaine fourchette de valeurs de la tension correspondante (U1, U2, U3), et dans lequel
- les signaux de sortie (PWM1, PWM2, PWM3) du régulateur (3) sont vérifiés au niveau de l'interface entre le régulateur (3) et le convertisseur (2), quant aux erreurs dans les signaux, au moyen d'un montage d'interprétation (5).

2. Procédé selon la revendication 1, **caractérisé en ce qu'**au moins l'un des courants de phase (11, 12, 13) est égal à zéro au niveau du point de la période à laquelle un mesurage est effectué.

3. Procédé selon l'une des revendications précédentes, **caractérisé en ce que** les différents courants de phase (11, 12, 13) sont décalés les uns par rapport aux autres, selon un écart constant, et le mesurage des courants de phase (11, 12) est effectué au niveau d'un point constant (120 DEG, 240 DEG, 360 DEG) d'une période des courants de phase (11, 12, 13).

4. Procédé selon l'une des revendications précédentes, **caractérisé en ce que** le rapport entre les tensions (U1, U2) différentes de zéro pendant chacun des mesurages de courant reste constant pendant le mesurage, et **en ce que** leur somme est égale à zéro pendant le mesurage.

5. Procédé selon l'une des revendications précédentes, **caractérisé en ce que** plusieurs mesurages des courants de phase (11, 12) sont réalisés au niveau d'un certain point prédéterminé de la période, pour la reconnaissance d'erreurs.

6. Procédé selon la revendication 5, **caractérisé en ce que** le nombre de mesurages de courant en différents points de la période correspond au nombre de phases (11, 12, 13) du moteur électrique (1).

7. Procédé selon les revendications 2 et 6, **caractérisé en ce que** pour chacun des mesurages, l'un des courants de phase (11, 12, 13) est égal à zéro.

8. Procédé selon l'une des revendications précédentes, **caractérisé en ce que** pour l'évaluation des courants de phase (11, 12) mesurés, les valeurs de mesure sont évaluées à l'aide de la progression des tensions correspondantes (U1, U2), en des points prédéterminés de la progression du courant.

9. Procédé selon l'une des revendications précédentes, **caractérisé en ce que** pour l'évaluation des courants de phase (11, 12) mesurés, les valeurs de mesure sont relevées sous forme de tableau.

10. Procédé selon l'une des revendications précédentes, **caractérisé en ce que** le comportement de l'un des courants de phase (13) est déterminé à partir des valeurs de mesure des autres courants de phase (11, 12).

11. Procédé selon la revendication 1, **caractérisé en ce que** les signaux de sortie (PWM1, PWM2, PWM3) du régulateur (3) varient selon un modèle prédéterminé et **en ce que** les signaux de tension (PWM.U1, PWM.U2, PWM.U3) produits en fonction de ce modèle du côté entrée au niveau du convertisseur (2) sont mesurés et évalués.

12. Procédé selon la revendication 11, **caractérisé en ce que** une erreur est considérée comme reconnue, lorsqu'aucun signal de tension (PWM.U1, PWM.U2, PWM.U3) attendu à partir des signaux de sortie (PWM1, PWM2, PWM3) du régulateur (3) n'apparaît.

13. Procédé selon la revendication 11 ou 12, **caractérisé en ce que** pour l'évaluation des signaux de tension (PWM.U1, PWM.U2, PWM.U3), différents signaux de tension (PWM.U1, PWM.U2, PWM.U3) du convertisseur (2), produits du côté entrée par les signaux de sortie (PWM1, PWM2, PWM3) du régulateur (3), sont reliés entre eux.

14. Procédé selon la revendication 13, **caractérisé en ce que** les signaux de tension (PWM.U1, PWM.U2, PWM.U3) sont reliés entre eux par au moins une porte logique (56, 57), en particulier sous forme de porte EXOR.

15. Procédé selon l'une des revendications précédentes, **caractérisé en ce que** lors de l'apparition d'une surintensité pendant le mesurage des courants de phase (11, 12, 13), il est vérifié s'il y a un court-circuit entre deux phases (11, 12, 13) du moteur électrique (1).

16. Procédé selon la revendication 15, **caractérisé en ce que** la vérification du court-circuit est effectuée lorsqu'une surintensité est apparue dans une soupape du convertisseur (26a à 28b) du convertisseur (2).

17. Procédé selon la revendication 15 ou 16, **caractérisé en ce que** pour la vérification d'un court-circuit, deux phases (12, 12 ; 11, 13 ; 12, 13) du moteur électrique (1) sont à chaque fois reliées à un même potentiel électrique (-U/2).

18. Procédé selon la revendication 17, **caractérisé en ce que** différentes phases (11, 12 ; 11, 13 ; 12, 13) du moteur électrique (1) sont reliées les unes après les autres à un même potentiel électrique (-U/2), afin de déterminer, au moyen de l'évaluation des courants apparaissant, entre quelles phases a lieu un court-circuit.

19. Procédé selon l'une des revendications précédentes, **caractérisé en ce qu'**en présence d'une surintensité dans une soupape de convertisseur (26a à 28b) du convertisseur (2), il est vérifié s'il y a un court-circuit à la terre dans l'une des phases (11, 12, 13) du moteur électrique (1).

20. Procédé selon la revendication 19, **caractérisé en ce que** pour la vérification d'un court-circuit à la terre, les circuits électriques (21, 22, 23) du convertisseur (2), qui sont connectés en amont des différentes phases (11, 12, 13) du moteur électrique (1) reçoivent des signaux d'entrée identiques (« 0 » ou « 1 »).

21. Procédé selon la revendication 19 ou 20, **caractérisé en ce que** pour effectuer le test du court-circuit à la terre, les tensions électriques (U1, U2, U3) au niveau des trois phases (11, 12, 13) du moteur électrique (1) sont réglées sur des valeurs identiques.

22. Procédé selon l'une des revendications précédentes, **caractérisé en ce que** le moteur électrique polyphasé (1) est conçu comme un moteur triphasé.
